# EUROPEAN PATENT SPECIFICATION

(11) **EP 4 131 445 B1**
(45) Date of publication and mention of the grant of the patent: **10.07.2024**
(21) Application number: 22185489.6
(22) Date of filing: 18.07.2022
(51) Int. Cl.: H10K 30/80, H01L 21/04

(54) **PHOTOELECTRIC CONVERSION DEVICE, ELECTRONIC DEVICE, AND POWER SUPPLY MODULE**
FOTOELEKTRISCHE UMWANDLUNGSVORRICHTUNG, ELEKTRONISCHE VORRICHTUNG UND STROMVERSORGUNGSMODUL
DISPOSITIF DE CONVERSION PHOTOÉLECTRIQUE, DISPOSITIF ÉLECTRONIQUE ET MODULE D'ALIMENTATION ÉLECTRIQUE

(30) Priority: 28.07.2021 JP 2021123028
(43) Date of publication of application: 08.02.2023
(73) Proprietor: Ricoh Company, Ltd., Tokyo 143-8555 (JP)
(72) Inventor: Hirano, Tomoya, Tokyo, 143-8555 (JP); Arai, Ryota, Tokyo, 143-8555 (JP); Ito, Takaya, Tokyo, 143-8555 (JP); Tamoto, Nozomu, Tokyo, 143-8555 (JP); Tanaka, Masato, Tokyo, 143-8555 (JP)
(74) Representative: Marks & Clerk LLP

(56) References cited:
- EP-A1- 2 858 099
- WO-A1-2010/095524
- WO-A1-2020/262110

## Description

### BACKGROUND OF THE INVENTION

### 1. Field of the Invention

The present invention relates to a photoelectric conversion device, an electronic device, and a power supply module.

### 2. Description of the Related Art

In recent years, realization of an Internet of Things (IoT) society, in which everything is connected to an internet thereby enabling comprehensive control, has been expected. To realize such IoT society, a large number of sensors are required to be attached to various devices to acquire data; then, for this, a power supply to run the large number of sensors is required. Wiring to the large number of sensors and the use of batteries are not practical; on top of this, from a growing social need to reduce an environmental impact, a power supply by an environmental power generating device is wanted.

Among these, the photoelectric conversion device is attracting an attention as the device that can generate an electricity wherever light is available. In particular, a flexible photoelectric conversion device is expected to have a high efficiency and to be able to follow various situations; thus, it is expected to be suitably applicable for a wearable device and the like.

For example, Applied Physics letters 108, 253301 (2016) and Japanese Journal of Applied Physics 54, 071602 (2015) report the result of a feasibility study of the photoelectric conversion device for a wearable device.

In general, an organic thin film solar cell is expected to be an environmental power generating device having a high efficiency as well as flexibility; and a photoelectric conversion device using a transparent base film as the base has been proposed in Japanese Unexamined Patent Application Publication No. 2014-220333.

WO 2010/095524 A1 and WO 2020/262110 A1 both disclose organic elements comprising sealing layers, said sealing layers comprising an insulating layer, a metal layer, and a base.

The structure of such photoelectric conversion device generally consists of a first electrode, an electron transport layer, a photoelectric conversion layer, a hole transport layer, and a second electrode; these being stacked in this order on a base, which is a support base. On the other hand, because the function of the photoelectric conversion device having such structure is degraded if water or the like penetrates into the interior thereof, a sealing member is further provided in order to prevent these external substances from penetrating into the interior of the photoelectric conversion device. For example, as the sealing member described above, a laminate film of an insulating layer with a metal layer is used; and in the photoelectric conversion device having the structure as described above, the said film is caused to cover the device from the second electrode side so as to bond to a member on the base side to perform the function as the sealing member.

However, in the photoelectric conversion device using the sealing member having the insulating layer, the metal layer, and the base in sequence, when a pressure is applied during manufacturing or use thereof, there is a problem in that an end thereof is deformed thereby causing the metal layer to contact with other layers including the electrode, resulting in an electrical malfunction.

### SUMMARY OF THE INVENTION

According to an aspect of the present invention, a photoelectric conversion device includes a first electrode, a photoelectric conversion layer, and a second electrode in sequence. The photoelectric conversion device includes a sealing member on a non-facing surface side of one electrode selected from the first electrode and the second electrode, the non-facing surface side not facing the photoelectric conversion layer. The sealing member includes an insulating layer, a metal layer, and a base in sequence from the one electrode. In an end of the sealing member in a surface direction, a length of the insulating layer in the surface direction is equal to or longer than a length of the metal layer in the surface direction, and the length of the metal layer in the surface direction is longer than a length of the base in the surface direction by 0.1 um or more.

According to an aspect of the present invention, a photoelectric conversion device having the occurrence of the electrical malfunction suppressed can be provided even when a pressure is applied during the manufacturing or use thereof.

### BRIEF DESCRIPTION OF THE DRAWINGS

FIG. 1 is an overlooking schematic view of one example illustrating a photoelectric conversion device;
FIG. 2 is a sectional schematic view of one example illustrating the photoelectric conversion device;
FIG. 3 is a sectional schematic view of the photoelectric conversion device illustrated in FIG. 2, having the sealing zone in the left end thereof enlarged;
FIG. 4 is an enlarged sectional schematic view of the sealing zone of the photoelectric conversion device not included in the present invention;
FIG. 5 is an enlarged sectional schematic view of the sealing zone of the photoelectric conversion device not included in the present invention;
FIG. 6A is a schematic view illustrating one example illustrating the manufacturing method of the photoelectric conversion module;
FIG. 6B is a schematic view illustrating one example illustrating the manufacturing method of the photoelectric conversion module;
FIG. 6C is a schematic view illustrating one example illustrating the manufacturing method of the photoelectric conversion module;
FIG. 6D is a schematic view illustrating one example illustrating the manufacturing method of the photoelectric conversion module;
FIG. 6E is a schematic view illustrating one example illustrating the manufacturing method of the photoelectric conversion module;
FIG. 6F is a schematic view of one example illustrating the manufacturing method of the photoelectric conversion module;
FIG. 6G is a schematic view of one example illustrating the manufacturing method of the photoelectric conversion module;
FIG. 6H is a schematic view of one example illustrating the manufacturing method of the photoelectric conversion module;
FIG. 6I is a schematic view of one example illustrating the manufacturing method of the photoelectric conversion module;
FIG. 6J is a schematic view of one example illustrating the manufacturing method of the photoelectric conversion module;
FIG. 6K is a schematic view of one example illustrating the manufacturing method of the photoelectric conversion module;
FIG. 7 is a schematic diagram of one example illustrating the basic configuration of an electronic device;
FIG. 8 is a schematic diagram of one example illustrating the basic configuration of the electronic device;
FIG. 9 is a schematic diagram of one example illustrating the basic configuration of the electronic device;
FIG. 10 is a schematic diagram of one example illustrating the basic configuration of a power supply module;
FIG. 11 is a schematic diagram of one example illustrating the basic configuration of the power supply module;
FIG. 12 is a schematic diagram of one example illustrating the basic configuration of a personal computer mouse;
FIG. 13 is a schematic appearance of one example illustrating the personal computer mouse illustrated in FIG. 12;
FIG. 14 is a schematic diagram of one example illustrating the basic configuration of a personal computer keyboard;
FIG. 15 is a schematic appearance of one example illustrating the personal computer keyboard illustrated in FIG. 14;
FIG. 16 is a schematic appearance of another example illustrating the personal computer keyboard illustrated in FIG. 14;
FIG. 17 is a schematic diagram of one example illustrating the basic configuration of a sensor;
FIG. 18 is a schematic diagram of one example illustrating wireless communication to transmit the data acquired by a sensor to a personal computer, a smartphone, or other device; and
FIG. 19 is a schematic diagram of one example illustrating the basic configuration of a turntable.

The accompanying drawings are intended to depict exemplary embodiments of the present invention and should not be interpreted to limit the scope of the appended claims. Identical or similar reference numerals designate identical or similar components throughout the various drawings.

### DESCRIPTION OF THE EMBODIMENTS

The terminology used herein is for the purpose of describing particular embodiments only and is not intended to be limiting of the appended claims.

As used herein, the singular forms "a", "an" and "the" are intended to include the plural forms as well, unless the context clearly indicates otherwise.

In describing preferred embodiments illustrated in the drawings, specific terminology may be employed for the sake of clarity. However, the appended claims are not intended to be limited to the specific terminology so selected, and it is to be understood that each specific element includes all technical equivalents that have the same function, operate in a similar manner, and achieve a similar result falling within the scope of the appended claims.

An embodiment of the present invention will be described in detail below with reference to the drawings.

### Photoelectronic Conversion Device Relating to Organic Thin Film Solar Cell

"The photoelectric conversion device" is the device that converts a light's energy into an electrical energy or an electrical energy into a light's energy. Specifically, examples thereof include the device composed of a solar cell, and a photodiode. Illustrative examples of the solar cell include an organic thin film solar cell, a dye-sensitized solar cell, and a perovskite solar cell. In the present disclosure, the photoelectric conversion device composed of the organic thin film solar cell will be described first, which is followed by the description about the dye-sensitized solar cell and the perovskite solar cell.

The photoelectric conversion device has at least a first electrode, a photoelectric conversion layer, and a second electrode in sequence. The term "in sequence" means that the electrodes and the layer are arranged in the above order as a whole, while other layers or the like may be inserted between the electrodes and the layer. Examples for the case in which other layers are inserted include the photoelectric conversion device having a first electrode, an electron transport layer, a photoelectric conversion layer, a hole transport layer, and a second electrode in sequence. In this case, on top of this, other layers or the like may be inserted between the electrode and the layer or between the layers. The term "in sequence" indicates here that these electrodes and layers may be stacked sequentially from the first electrode side or from the second electrode side. Specifically, when viewed from the incident surface side, the photoelectric conversion device may be stacked sequentially in the order of the first electrode, the photoelectric conversion layer, and the second electrode, or in the order of the second electrode, the photoelectric conversion layer, and the first electrode. When the photoelectric conversion device has the electron transport layer and the hole transport layer, when viewed from the incident surface side, the photoelectric conversion device may have the configuration in which the first electrode, the electron transport layer, the photoelectric conversion layer, the hole transport layer, and the second electrode are sequentially stacked in this order, or that the second electrode, the hole transport layer, the photoelectric conversion layer, the electron transport layer, and the first electrode are sequentially stacked in this order. In the present disclosure, the explanation will be mainly given to the case in which the first electrode, the electron transport layer, the photoelectric conversion layer, the hole transport layer, and the second electrode are stacked sequentially in this order when viewed from the incident surface side, but this photoelectric conversion device is not limited to the case like this. From the description above, a person skilled in the art can easily understand an embodiment in which the second electrode, the hole transport layer, the photoelectric conversion layer, the electron transport layer, and the first electrode are stacked sequentially in this order when viewed from the incident surface side, and the like.

The photoelectric conversion device has a sealing member. The sealing member is arranged on the non-facing surface side not facing the photoelectric conversion layer of one electrode selected from the first electrode and the second electrode (hereinafter, this is also referred to as "one electrode"). In the present disclosure, "one electrode" is, of the first and the second electrode, the electrode that is arranged in the location farer away from the incident surface. Another electrode selected from the first and the second electrode (hereinafter, this is also referred to as "the other electrode") is, of the first and the second electrode, the electrode that is arranged in the location closer to the incident surface. The "non-facing surface" represents the surface opposite to the surface that faces the photoelectric conversion layer directly, or indirectly via other layer. The term "non-facing surface side" indicates that the sealing member only needs to be located on the non-facing surface side of the one electrode, and that the sealing member and the one electrode may or may not be adjacent to each other. When the sealing member and the one electrode are not adjacent, other layer or the like may be inserted between the sealing member and the one electrode; so, for example, a surface protection portion to be described later may be inserted. Also, "arranged on the non-facing surface side" means that at least a part of the sealing member needs to be located on the non-facing surface side of the one electrode, so that the whole of the sealing member is not necessarily located on the non-facing surface side of the one electrode. It is preferable that the sealing member encapsulate the one electrode and the photoelectric conversion layer, and when the photoelectric conversion device has the electron transport layer and the hole transport layer, it is preferable that the electron transport layer and the hole transport layer be further encapsulated.

The photoelectric conversion device has a surface protection portion, as needed. The surface protection portion is arranged adjacent to the non-facing surface side of the one electrode.

The photoelectric conversion device has a base (this is distinguished from the base that constitutes the sealing member to be described later; so, this may be referred to as the "device base"), a UV-cut layer, and the like, as needed.

When having the base, it is preferable that the photoelectric conversion device have, when viewed from the incident surface side, the configuration in which the base, the first electrode, the electron transport layer, the photoelectric conversion layer, the hole transport layer, and the second electrode are stacked sequentially in this order, or the configuration in which the base, the second electrode, the hole transport layer, the photoelectric conversion layer, the electron transport layer, and the first electrode are stacked sequentially in this order. Also, it is preferable that the base be arranged adjacent to the other electrode on the side not facing the photoelectronic conversion layer of the other electrode.

### Base (Device Base)

The "base (device base)" is the member that supports the electrodes, the layers, and the like, that constitute the photoelectric conversion device. From a viewpoint to enhance the photoelectric conversion efficiency, it is preferable that the base be high in light permeability, while more preferably transparent. In addition, from a viewpoint to widen the application thereof, it is preferable that the base have high flexibility.

Illustrative examples of the transparent and flexible base include resin films of polyesters such as polyethylene terephthalate (PET), a polycarbonate, a polyimide, a polymethyl methacrylate, a polysulfone, a polyether ether ketone, as well as a thin glass film (glass having the thickness of 200 um or less). Among these materials, from viewpoints of easy production and cost, resin films of a polyester and of a polyimide, as well as a thin glass film are preferable. When the resin film or the thin glass film is used as the base, the thickness of the base is preferably 200 um or less. When the base has the thickness of 200 um or less, the flexibility thereof is enhanced so that the durability thereof can be improved as well, even when the photoelectric conversion device is bent. The thickness of the base can be measured by a publicly known method, for example, using a contact-type thickness gauge.

Illustrative examples of the material for the base having transparency but lacking flexibility include an inorganic transparent crystalline material such as a glass other than the thin glass film (in other words, a glass having the thickness of more than 200 µm). These materials are preferable because they are not flexible but highly flat.

It is preferable that the base have a gas barrier property. The gas barrier property relates to a function to inhibit the permeation of a water vapor, oxygen, and the like. In the present disclosure, the "base having a gas barrier property" is not limited to those in which the base itself has the gas barrier property; but this also includes those having a gas barrier layer, which is the layer having the gas barrier property, at the position adjacent to the base. The base having the gas barrier property can provide the photoelectric conversion device having a high storage durability, in which the decrease in the photoelectric conversion efficiency can be further suppressed even when the device is placed in a high temperature and high humidity environment for a long time. The gas barrier layer is to be described later.

In general, the function that is required for the base having the gas barrier property is expressed in terms of a water vapor permeability, an oxygen permeability, and the like. The water vapor permeability per day in accordance with the JIS K7129 B method is preferably, for example, 10 g/m² or less, although the lower the better. The oxygen permeability per day in accordance with JIS K7126-2 is preferably, for example, 1 cm³/m²·atm or less, although the lower the better.

As for the resin film having the gas barrier property, publicly known films can be used as appropriate. Examples thereof include an aluminum-coated resin film, and a silicon oxide-coated resin film.

### First Electrode

The "first electrode" is the electrode that collects electrons generated by photoelectric conversion. When the first electrode is arranged on the incident surface side, from a viewpoint to enhance the photoelectric conversion efficiency, it is preferable that the first electrode be high in light permeability, while more preferably transparent. However, when the first electrode is arranged on the side opposite to the incident surface, this may be low in the light permeability and transparency.

As for the first electrode having transparency, a transparent electrode that is transparent to a visible light can be used. The transparent electrode is, for example, a structural body composed of a transparent conductive film, a metal thin film, and a transparent conductive film in sequence. The two transparent conductive films having the metal thin film interposed therebetween may be formed from the same material or from different materials.

Illustrative examples of the material for the transparent conductive film include a tin-doped indium oxide (ITO), a zinc-doped indium oxide (IZO), a zinc oxide (ZnO), a fluorine-doped tin oxide (FTO), an aluminum-doped zinc oxide (AZO), a gallium-doped zinc oxide (GZO), a tin oxide (SnO2), a silver nanowire, and a nanocarbon (carbon nanotube, graphene, or the like). Among these materials, a tin-doped indium oxide (ITO), a zinc-doped indium oxide (IZO), and an aluminum-doped zinc oxide (AZO) are preferable.

Illustrative examples of the material for the metal thin film include thin films formed from metals such as aluminum, copper, silver, gold, platinum, and nickel.

From a viewpoint of maintaining rigidity, the first electrode that has transparency and is integrated with the base described before is preferably used. Illustrative examples thereof include an FTO-coated glass, an ITO-coated glass, an aluminum-coated glass, an FTO-coated transparent plastic film, an ITO-coated transparent plastic film, and a plastic film coated with an ITO/silver/ITO laminate.

Illustrative examples of the material for the non-transparent first electrode include metals such as platinum, gold, silver, copper, and aluminum, as well as graphite.

The average thickness of the first electrode is preferably 5 nm or more and 10 um or less, while more preferably 50 nm or more and 1 um or less.

The sheet resistance of the first electrode is preferably 50 Ω/sq. or less, and more preferably 30 Ω/sq. or less, while still more preferably 20 Ω/sq. or less.

When the first electrode is transparent, the light transmittance of the first electrode is preferably 60% or greater, more preferably 70% or greater, and still more preferably 80% or greater, while especially preferably 90% or greater. There is no particular restriction in the upper limit thereof; so, this can be selected as appropriate in accordance with the purpose.

The first electrode may be formed by a wet coating method, a dry coating method such as a vapor deposition method and a sputtering method, and a printing method.

### Electron Transport Layer

The "electron transport layer" is the layer that transports an electron generated in the photoelectric conversion layer and inhibits the entry of a hole generated in the photoelectric conversion layer. The electron transport layer may have a structure consisting of one layer, or two or more layers. As one example, the case of a structure having two electron transport layers will be described hereinafter. Specifically, the structure has a first electron transport layer and a second electron transport layer (also called "intermediate layer") that is arranged between the first electron transport layer and a photoelectric conversion layer. When the structure of the electron transport layer consists of one layer, this is preferably the same as the first electron transport layer.

### First Electron Transport Layer

The first electron transport layer is preferably the layer containing metal oxide particles.

Illustrative examples of the metal oxide include oxides of titanium, zinc, lithium, and tin, as well as ITO, FTO, ATO, AZO, and GZO. Among these, zinc oxide is preferable, while more preferable is a zinc oxide that is doped so as to enhance the conductivity thereof. Illustrative Examples of the doped zinc oxide include an aluminum-doped zinc oxide, a gallium-doped zinc oxide, and a lithium-doped zinc oxide. The metal oxide may be made from a metal alkoxide or the like as the raw material thereof.

The average particle diameter of the metal oxide particle is preferably 1 nm or more and 50 nm or less, while more preferably 5 nm or more and 20 nm or less.

The average particle diameter of the metal oxide particle is obtained, for example, by measuring at least 100 randomly selected particles of the metal oxide by the method described below to calculate the average value of these measurements. First, a dispersion solution containing metal oxide particles is transferred to a glass nebulizer using a micropipette. Next, the dispersion liquid is sprayed from a nebulizer onto a grid attached with a collodion membrane for TEM. Using a PVD method, the grid is vapor-deposited with carbon, and an image of the metal oxide particles is obtained by an electron microscopy. The resulting image is image-processed to measure the particle diameter of the metal oxide particle. The particle diameter of the metal oxide particle may also be measured by observing the section of the photoelectric conversion device using a scanning transmission electron microscope (TEM) followed by particle recognition using the image processing. The particle size distribution may also be measured by a laser diffraction and scattering method. Cutting out of the section of the photoelectric conversion device, observation by TEM, and measurement of particle size distribution can be done by a publicly known method.

The average thickness of the first electron transport layer is preferably 1 nm or more and 300 nm or less, while more preferably 10 nm or more and 150 nm or less.

Examples of the production methods of the first electron transport layer include, for example, a method of applying a dispersion liquid containing metal oxide particles and a dispersing medium followed by drying this. Illustrative examples of the dispersing medium include alcohols such as methanol, ethanol, isopropanol (2-propanol), 1-propanol, 2-methoxyethanol, and 2-ethoxyethanol, as well as mixtures thereof.

### Second Electron Transport Layer (Intermediate Layer)

The second electron transport layer is preferably the layer containing an amine compound. Although the amine compound is not particularly restricted as far as this is the material that can enhance the photoelectric conversion efficiency of the photoelectric conversion device by arranging the second electron transport layer, it is preferable to use, for example, an amine compound represented by the following general formula (4).

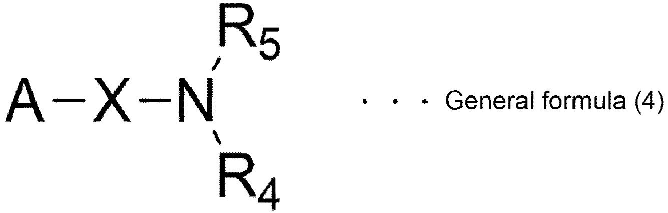

In the general formula (4), R₄ and R₅ each represent an alkyl group which may have a substituent and has the carbon number of 1 or more and 4 or less or a ring structure bonded to R₄ and R₅, in which the alkyl group which may have the substituent and has the carbon number of 1 or more and 4 or less is preferable, while an alkyl group having no substituent and having the carbon number of 1 or more and 4 or less is more preferable. Illustrative examples of the substituent described above include a methyl group, an ethyl group, and a hydroxyl. The carbon number in the ring structure is preferably 3 or more and 6 or less. When R₄ and R₅ each is the alkyl group which may have the substituent and has the carbon number of 1 or more and 4 or less, the alkyl groups in R₄ and R₅ may be the same or different.

In the above general formula (4), X represents a divalent aromatic group having the carbon number of 6 or more and 14 or less or a divalent alkyl group having the carbon number of 1 or more and 4 or less, in which the divalent aromatic group having the carbon number of 6 or more and 14 or less is preferable.

In the above general formula (4), A represents any of the substituents represented by the following structural formulae (1) to (3), in which the substituent represented by the structural formula (1) is preferable.

-COOH ··· Structural formula (1)

-P(=O)(OH)₂ ··· Structural formula (2)

-Si(OH)₃ ··· Structural formula (3)

Illustrative examples of the amine compound other than the general formula (4) include 3-aminopropyl triethoxysilane, 3-aminopropyl trimethoxysilane, 3-aminopropyl diethoxy methylsilane, 3-(2-aminoethylamino)propyl trimethoxysilane, 3-(2-aminoethylamino)propyl dimethoxy methylsilane, 3-(2-aminoethylamino)propyl triethoxysilane, trimethoxy [3-(phenylamino)propyl]silane, trimethoxy [3-(methylamino)propyl]silane, bis[3-(trimethoxysilyl)propyl]amine, bis[3-(triethoxysilyl)propyl]amine, and N,N'-bis[3-(trimethoxysilyl)propyl]ethane-1,2-diamine.

Illustrative examples of the method for producing the second electron transport layer include a method performing a spin-coating method in which a solution containing the amine compound is spin-coated or performing a dipping method, and subsequent drying.

### Photoelectric Conversion Layer

The "photoelectric conversion layer" is the layer that generates an electron and a hole by absorbing light. The photoelectric conversion layer contains two or more organic materials, specifically a donor organic material (also called a p-type organic semiconductor material) and an acceptor organic material (also called a n-type organic semiconductor material). Each of the donor and acceptor organic materials may be made of a plurality of organic materials, so that it is preferable that the photoelectric conversion layer contain three or more types of organic materials. In the photoelectric conversion layer, it is preferable that the donor and acceptor organic materials be mixed to form a bulk heterostructure.

### Donor Organic Material

The donor organic material is preferably a π-electron conjugated compound having a highest occupied molecular orbital (HOMO) level of 4.8 eV or more and 5.7 eV or less, while more preferably a n-electron conjugated compound having the level of 5.1 eV or more and 5.5 eV or less, or 5.2 eV or more 5.6 eV and less.

The highest occupied molecular orbital (HOMO) level can be obtained by measurement with a photoelectron yield spectroscopy, a cyclic voltammetry, or the like. Specifically, this may be measured using an instrument such as AC-3 manufactured by Riken Keiki Co., Ltd.

Illustrative examples of the donor organic material include a porphyrin and a phthalocyanine, which are conjugated polymers or low molecular weight conjugated compounds in which various aromatic derivatives (for example, thiophene, fluorene, carbazole, thienothiophene, benzodithiophene, dithienosilole, quinoxaline, and benzothiadiazole) are coupled. The donor organic material may also be a donor-acceptor linked material having an electron-donating moiety and an electron-accepting moiety in its molecular structure, or the like.

The number-average molecular weight (Mn) of the donor organic material, when this is a low molecular weight molecule, is preferably 10,000 or less, while more preferably 5,000 or less. When the material is a polymer, the molecular weight thereof is preferably 10,000 or more.

In one preferable example of the donor organic material, the highest occupied molecular orbital (HOMO) level thereof is 5.1 eV or more and 5.5 eV or less and the number-average molecular weight (Mn) is 10,000 or less. Examples of the organic material like this include those compounds represented by the following general formula (1).

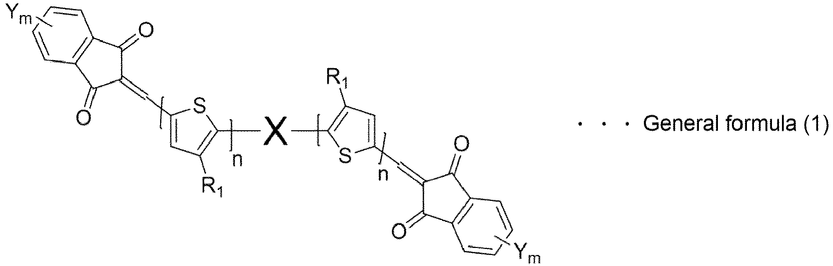

In the general formula (1) R₁ represents an alkyl group having the carbon number of 2 or more and 8 or less.

In the general formula (1), n represents an integer of 1 or more and 3 or less.

In the general formula (1), Y represents a halogen atom.

In the above general formula (1), m represents an integer of 0 or more and 4 or less.

In the general formula (1), X is represented by the following general formula (2) or the following general formula (3).

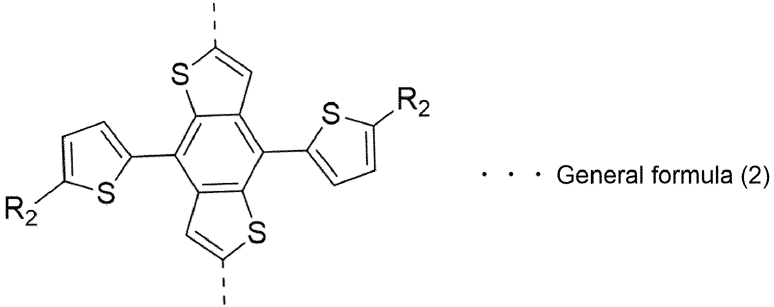

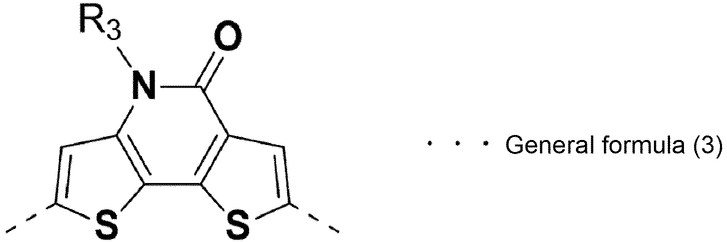

In the general formula (2), R₂ represents a linear or a branched alkyl group, preferably a linear or a branched alkyl group having the carbon number of 2 or more and 30 or less.

In the general formula (3), R₃ represents a linear or a branched alkyl group, preferably a linear or a branched alkyl group having the carbon number of 2 or more and 30 or less.

In another preferable example of the donor organic material, the highest occupied molecular orbital (HOMO) level is 5.2 eV or more and 5.6 eV or less and the number-average molecular weight (Mn) is 10,000 or more. Note that, it is preferable that this organic material be used in combination with the above-described organic material that has the highest occupied molecular orbital (HOMO) level of 5.1 eV or more and 5.5 eV or less and the number-average molecular weight (Mn) of 10,000 or less.

Illustrative examples of the organic material having the highest occupied molecular orbital (HOMO) level of 5.2 eV or more and 5.6 eV or less and the number-average molecular weight (Mn) of 10,000 or more include a 2,1,3-benzothiadiazole-thiophene type copolymer, a quinoxaline-thiophene type copolymer, a thiophene-benzodithiophene type copolymer, and a polyfluorene type polymer.

The 2,1,3-Benzothiadiazole-thiophene type copolymer is represented by the conjugated copolymer having a thiophene skeleton and a 2,1,3-benzothiadiazole skeleton in the main chain thereof. Specific examples of the 2,1,3-benzothiadiazole-thiophene type copolymer include those represented by the following general formulae (5) to (8). In the following general formulae (5) to (8), each n independently represents an integer of 1 or more and 1,000 or less.

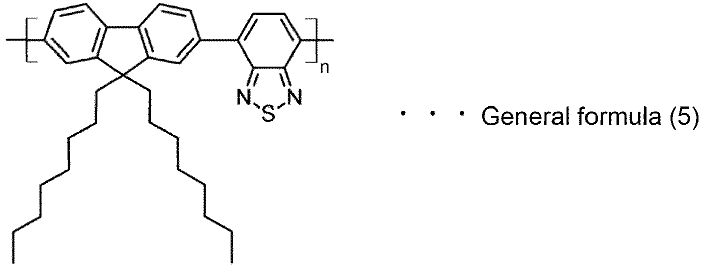

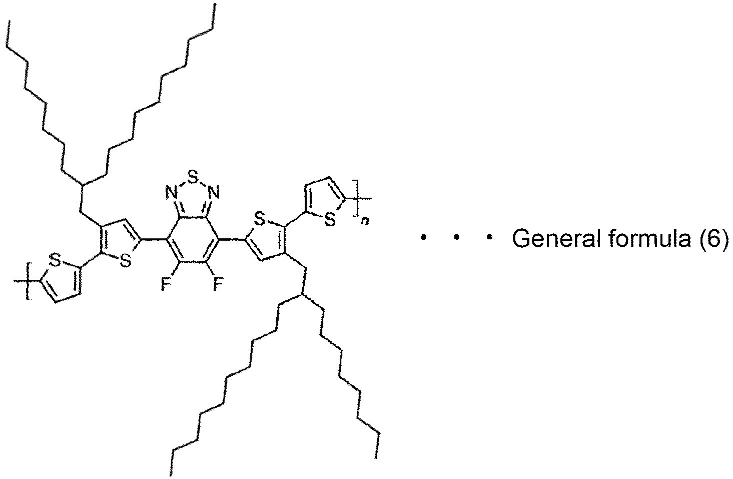

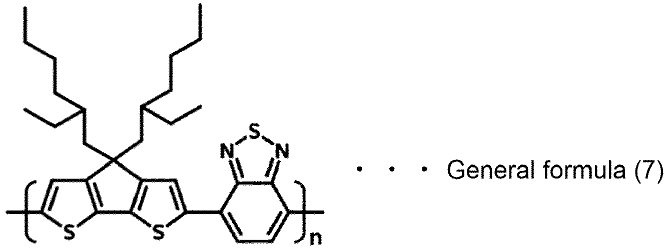

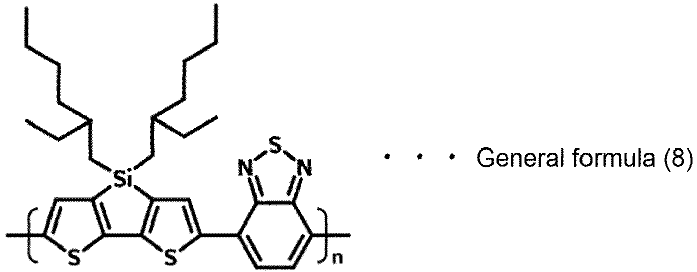

The quinoxaline-thiophene type copolymer represents the conjugated copolymer having a thiophene skeleton and a quinoxaline skeleton in the main chain thereof. Specific examples of the quinoxaline-thiophene type copolymer include those represented by the following general formula (9). In the general formula (9), n represents an integer of 1 or more and 1,000 or less.

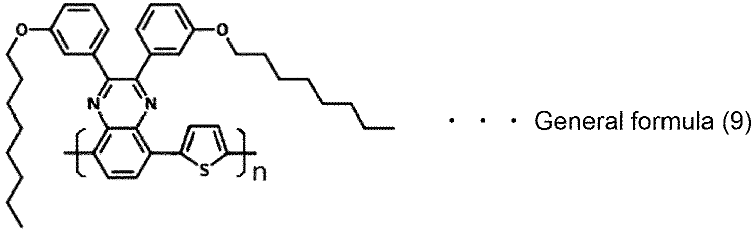

The thiophene-benzodithiophene type copolymer represents the conjugated copolymer having a thiophene skeleton and a benzodithiophene skeleton in the main chain thereof. Specific examples of the thiophene-benzodithiophene type copolymer include those represented by the following general formulae (10) to (13). In the general formulae (10) to (13), each n independently represents an integer of 1 or more and 1,000 or less. 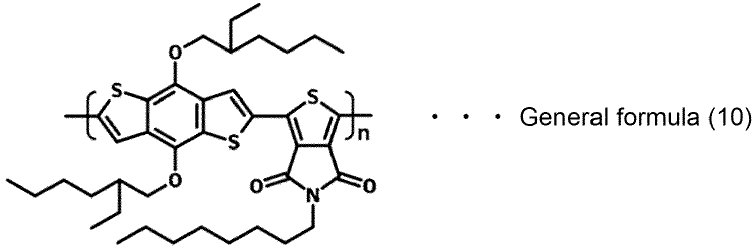 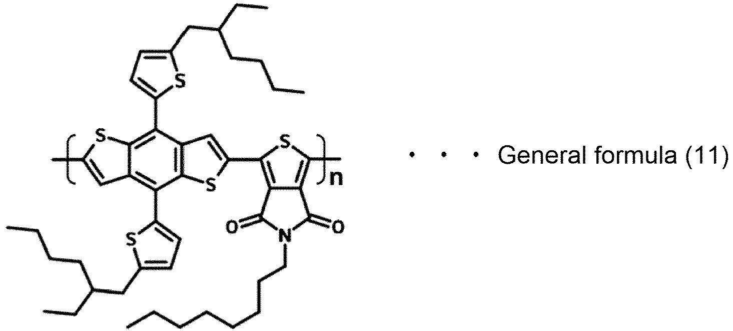 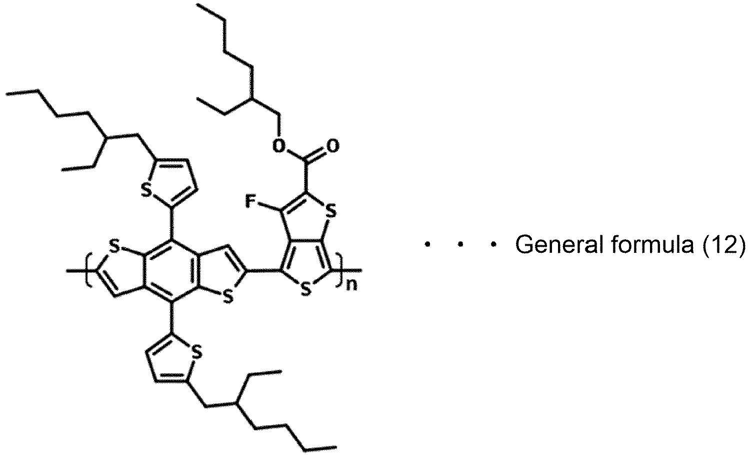 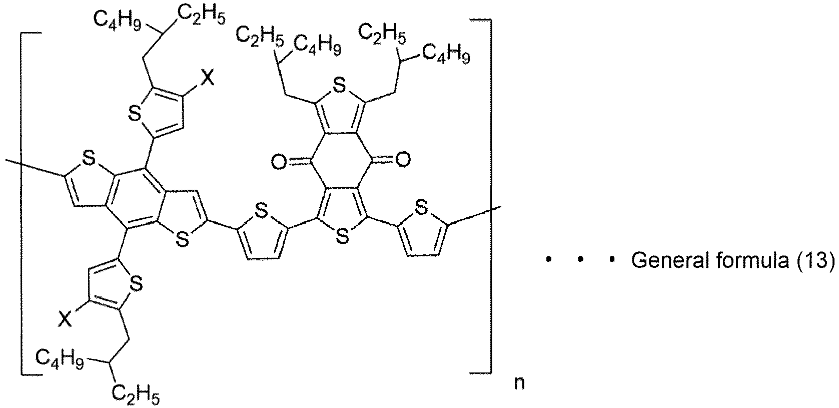 X=H, F, Cl, Br, I

### Acceptor Organic Material

The acceptor organic material is preferably a π-electron conjugated compound having the lowest unoccupied molecular orbital (LUMO) level of 3.5 eV or more and 4.5 eV or less.

Illustrative examples of the acceptor organic material include a fullerene or a derivative thereof, a naphthalene tetracarboxylic acid imide derivative, and a perylene tetracarboxylic acid imide derivative. Among these, a fullerene derivative is preferable.

Illustrative examples of the fullerene derivative include C₆₀, methyl phenyl-C₆₁-lactate (fullerene derivatives described as PCBM, [60]PCBM, or PC₆₁BM in published literatures and the like), C₇₀, methyl phenyl-C₇₁-lactate (fullerene derivatives described as PCBM, [70]PCBM, or PC₇₁BM in published literatures and the like), and a fulleropyrrolidine type fullerene derivative represented by the following general formula (14).

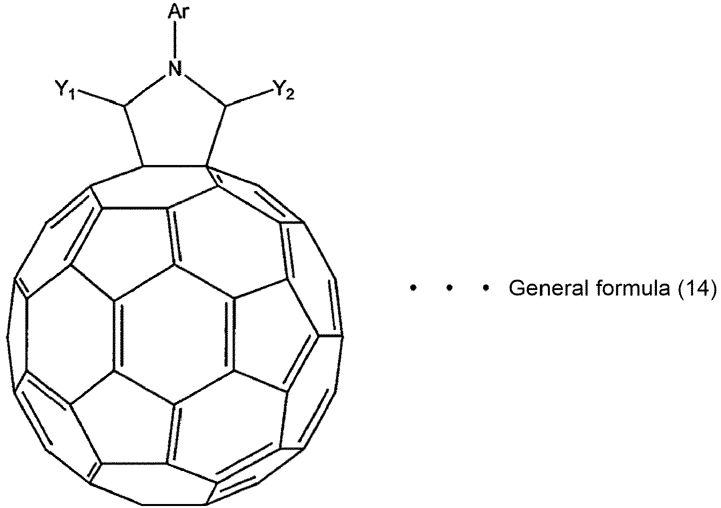

In the general formula (14) Y₁ and Y₂ each independently represent a hydrogen atom, an alkyl group, an alkenyl group, an alkynyl group, an aryl group, or an aralkyl group. However, Y₁ and Y₂ are not hydrogen atoms simultaneously. The alkyl group, the alkenyl group, the alkynyl group, the aryl group, and the aralkyl group described above may or may not have a substituent.

In the general formula (14), Ar represents an aryl group. The aryl group may or may not have a substituent.

### Average Thickness of Photoelectric Conversion Layer

The average thickness of the photoelectric conversion layer is preferably 50 nm or more and 400 nm or less, while more preferably 60 nm or more and 250 nm or less. When the average thickness is 50 nm or more, the amount of the carrier due to the light absorption in the photoelectric conversion layer is sufficient. When the average thickness is 400 nm or less, the decrease in the transport efficiency of the carrier generated by light absorption is suppressed.

The average thickness of the photoelectric conversion layer is calculated, for example, by measuring the thickness of the photoelectric conversion layer at the randomly selected 9 points by the following method to determine the average value of these measurements. First, a liquid containing the material that constitutes the photoelectric conversion layer is applied to a base, dried, and then wiped off at an arbitrary point with a solvent. Then, the height of the stage in the wiped portion is measured using DEKTAK manufactured by Bruker Corp. to obtain the measured value as the thickness. The average thickness of the photoelectric conversion layer may also be measured by observing the section of the photoelectric conversion device by using a scanning electron microscope (SEM) or a transmission electron microscope (TEM).

### Method for Formation of Bulk Heterojunction in Photoelectric Conversion Layer

The photoelectric conversion layer may be the layer that has a planar junction interface by sequentially stacking each of the above-mentioned organic materials. But, in order to increase the area of the junction interface, it is preferable to form a bulk heterojunction having the structure in which these organic materials are three-dimensionally mixed. The bulk heterojunction is formed, for example, as follows.

When each organic material is a highly soluble material, each organic material is dissolved in a solvent to obtain a solution in which these organic materials are mixed in the molecular state; then, after the mixture is applied, this is dried to remove the solvent. In this case, the agglomeration state of each organic material may be optimized by further conducting a heat treatment.

On the other hand, when using organic materials having low solubility, a liquid in which one organic material is dispersed into the solution having other organic material dissolved therein is prepared; then, after this liquid is applied, drying is carried out to remove the solvent. In this case, the agglomeration state of each organic material may be optimized by further conducting a heat treatment.

### Method for Forming Photoelectric Conversion Layer

The method for forming the photoelectric conversion layer includes the process at which the liquid containing the above-mentioned organic materials is provided. Illustrative examples of the providing method include a spin coating method, a blade coating method, a slit die coating method, a screen printing method, a bar coating method, a casting method, a printing transfer method, a dip pulling method, an ink-jetting method, a spraying method, and a vacuum vapor deposition method. From these, the method is selected as appropriate in accordance with the characteristics of the photoelectric conversion layer to be formed, such as a thickness control and an orientation control.

For example, when the spin coating method is used, it is preferable to use a solution containing each of the above organic materials at a concentration of 5 mg/mL or more and 40 mg/mL or less. The concentration is the total mass of these organic materials relative to the volume of the solution containing these organic materials. By setting to the above concentration, the photoelectric conversion layer that is homogeneous can be readily prepared.

An annealing treatment may be performed under a reduced pressure or in an inert atmosphere (in a nitrogen or an argon atmosphere) to remove a solvent or a dispersing medium from the liquid containing the organic materials that have been applied. The temperature at the annealing process is preferably 40°C or more and 300°C or less, while more preferably 50°C or more and 150°C or less. The annealing treatment is desirable because this may lead to the increase in the contact area at the interface between the stacked layers by allowing the materials comprising each layer to penetrate to each other, resulting in the increase in a short-circuit current.

Illustrative examples of the solvent for dissolving or dispersing the organic materials include methanol, ethanol, butanol, toluene, xylene, o-chlorophenol, acetone, ethyl acetate, ethylene glycol, tetrahydrofuran, dichloromethane, chloroform, dichloroethane, chlorobenzene, dichlorobenzene, trichlorobenzene, ortho-dichlorobenzene, chloronaphthalene, dimethylformamide, dimethyl sulfoxide, N-methylpyrrolidone, and γ-butyrolactone. These may be used singly, or in combination of two or more of them. Among these, chlorobenzene, chloroform, and ortho-dichlorobenzene are especially preferable.

The above solvent or dispersing medium may contain various additives. Illustrative examples of the additives include diiodooctane and octane dithiol.

### Hole Transport Layer

The "hole transport layer" is the layer that transports a hole generated in the photoelectric conversion layer and inhibits penetration of the electron generated in the photoelectric conversion layer. The hole transport layer may have a structure consisting of one layer or of two or more layers. Hereinafter, as one example thereof, the structure having one layer of the hole transport layer will be described.

It is preferable that the hole transport layer be the layer that contains at least one compound selected from an organic compound and an inorganic compound having the hole transportable property. Illustrative examples of the organic compound having the hole transportable property include a conductive polymer such as PEDOT:PSS (polyethylene dioxythiophene:polystyrenesulfonic acid) and an aromatic amine derivative. Illustrative examples of the inorganic compound having the hole transportable property include molybdenum oxide, tungsten oxide, vanadium oxide, nickel oxide, and copper(I) oxide. Among these compounds having the hole transportable property, molybdenum oxide, tungsten oxide, and vanadium oxide are preferable.

The average thickness of the hole transport layer is preferably 200 nm or less, while more preferably 1 nm or more and 50 nm or less.

Illustrative examples of the method for producing the hole transport layer include the method in which the liquid containing a compound having the hole transportable property, as well as a solvent or a dispersing medium is applied followed by drying this liquid. Illustrative examples of the application method include a spin coating method, a sol-gel method, a slit die coating method, and a sputtering method.

### Second Electrode

The "second electrode" is the electrode that collects the holes generated by the photoelectric conversion. When the second electrode is arranged on the incident surface side, from a viewpoint to enhance the photoelectric conversion efficiency, it is preferable that the second electrode be high in light permeability, while more preferably transparent. However, when the second electrode is arranged on the side opposite to the incident surface, this may be low in the light permeability and transparency.

The second electrode may be the same as the first electrode described before; so, the description of this electrode is omitted.

### Surface Protection Portion

The "surface protection portion (also called "passivation layer" when layered)" is a member that prevents direct contact between the sealing member and, of the first and the second electrode, the electrode that is arranged in the location farer away from the incident surface, and that is arranged between the one electrode and the sealing member. Although the shape of the surface protection portion is not particularly restricted, this is preferably layered. When the surface protection portion is arranged on the one electrode (specifically, when this is arranged adjacent to the non-facing surface not facing the photoelectric conversion layer of the one electrode), water or oxygen that has penetrated from the outside can be suppressed from coming into contact with the one electrode; thus, corrosion, deterioration, or the like over time in the one electrode can be suppressed, resulting in improvement of the storage durability. In addition, the photoelectric conversion device can be configured such that the adhesive member that constitutes the sealing member does not come into direct contact with the one electrode, so that the problem of delamination caused by transfer of the material constituting one electrode to the adhesive member side is suppressed.

It is preferable that the surface protection portion cover the entirety of the exposed surface in the one electrode. The function of the surface protection portion described above is further enhanced when the entirety of the exposed surface in the one electrode is covered. The exposed surface in the one electrode means specifically the non-facing surface, a side surface, and the like, in the one electrode.

Illustrative examples of the material that constitutes the surface protection portion include metal oxides such as SiOx, SiOxNy, and Al₂O₃, as well as polyethylene, a fluorine-based coating material, and polymers such as poly-para-xylylene. These may be used singly, or in combination of two or more of them. Among these, the fluorine-based coating material is preferable.

When the fluorine-based coating material is used, examples as the material that constitutes the surface protection portion include a compound derived from a fluorine-based silane compound (also referred to as "fluorine-containing silane compound"). In other words, this indicates the use of the fluorine-based silane compound as the material for forming the surface protection portion. The fluorine-based silane compound is highly reactive with various metals or metal oxides that can constitute the one electrode, so that they can form a thin and uniformly flat surface protection portion on the one electrode. Because the thin film surface protection portion can be formed, the flexibility of the surface protection portion is enhanced. Therefore, even when the photoelectric conversion device is bent, a damage in the surface protection portion is suppressed, resulting in suppression of an electrode delamination at the first electrode of the photoelectric conversion device and of a deterioration in the storage durability. In addition, the surface protection portion containing the compound derived from the fluorine-based silane compound has a high degree of water repellency, a stain resistance, a weather resistance, and an abrasion resistance. In addition, because the fluorine-based silane compound can be dissolved in a non-fluorine-based organic solvent instead of a fluorine-based organic solvent for use, this is easy to handle.

Here, the fluorine-based silane compound is the fluorine-containing compound having an alkoxysilyl group. The alkoxysilyl group is not particularly restricted as far as this is the group having 1 to 3 alkoxy groups bonded to a silicon atom, in which illustrative examples of the alkoxy group include a methoxy group, an ethoxy group, and a propoxy group. The compound derived from the fluorine-based silane compound that constitutes the surface protection portion may be chemically bonded to the one electrode by reacting the fluorine-based silane compound with the one electrode, as described above. In other words, the surface protection portion is not limited to an independent member that is not chemically bonded to the one electrode, but may be chemically bonded to the one electrode when there is a functional difference from the one electrode.

As for the fluorine-based silane compound, it is preferable to use, for example, the compound represented by the following general formula (A). By using the compound represented by the general formula (A), an electrode delamination and a deterioration in the storage durability are suppressed furthermore in the photoelectric conversion device.

CF₃(CF₂)_{q}-O(CF₂CF₂O)ₘ(CF₂)ₚ(CH₂)ₙSᵢR¹₍₃₋ₐ₎(OR²)ₐ ... General formula (A)

(In the general formula (A), R1 and R² each independently represent a monovalent hydrocarbon group having the carbon number of 1 or more and 4 or less, a represents an integer of 2 or more and 3 or less, p represents an integer of 1 or more and 2 or less, q represents an integer of 0 or more and 5 or less, m represents an integer of 1 or more and 3 or less, n represents an integer of 2 or more and 4 or less, and p + q + 2m + n is an integer of 5 or more and 14 or less.)

The average thickness of the surface protection portion is preferably 1 um or less. When the thickness is 1 um or less, the flexibility of the surface protection portion is enhanced. Therefore, even when the photoelectric conversion device is bent, a damage in the surface protection portion is suppressed, resulting in further suppression of an electrode delamination in the first electrode of the photoelectric conversion device and of a deterioration in the storage durability. There is no particular restriction in the measurement method of the average thickness of the surface protection portion, so that any publicly known measurement method can be used. For example, the thickness can be measured using a stylus-type thin film step profiler, a white light interference microscope, and an atomic force microscope. The thickness is measured at five or more different locations in the surface protection portion, and the average value of these measurements is used.

In the past, metal oxides such as SiOx, SiOxNy, and Al₂O₃, as well as polyethylene, a fluorine-based coating material, and polymers such as polyparaxylylene have been used as the material that constitute the surface protection portion. However, these conventional materials have manufacturing difficulties to form a thin surface protection portion; specifically, it is especially difficult to reduce the thickness thereof to 1 um or less, so that the flexibility of the surface protection portion has been insufficient. As a result, when the photoelectric conversion device having the surface protection portion formed of a conventional material is bent, the bending stress causes cracks in the surface protection portion, from which water and oxygen can penetrate, so that the storage durability has been deteriorated. In this regard, when a compound derived from the fluorine-based silane compound is used as the material that constitutes the surface protection portion, it becomes easier to reduce the average thickness of the surface protection portion to 1 um or less, so that the flexibility of the surface protection portion is improved, and therefore the storage durability is enhanced as well.

Illustrative examples of the method for manufacturing the surface protection portion include a manual coating method, a nozzle flow coating method, a dipping method, a spraying method, a reverse coating method, a flow coating method, a spin coating method, and a roll coating method.

### Sealing Member

The "sealing member" is the member that prevents external substances such as water and oxygen from penetrating into the photoelectric conversion device and coming into contact with each of the layers. It is preferable for the sealing member to have, from the one electrode side, an adhesive member that enables the sealing member to be bonded to other members, and a gas barrier member that prevents external substances from penetrating into the photoelectric conversion device in sequence, while it is more preferable for these members to be integrated into a film-type member. The term "in sequence" means that these members may be arranged in the above order as a whole; so, other members or layers, or the like may be inserted between the adhesive member and the gas barrier member. When the sealing member is arranged on the side opposite to the incident surface, the sealing member is not necessary to have light permeability or transparency. It is preferable for the sealing member to be the member that constitutes the outermost portion of the photoelectric conversion device; in this case, each member that constitutes the sealing member (the adhesive member, the gas barrier member, and the like) is also at least partially exposed to the outside.

The functions required for the gas barrier material are generally expressed in terms of a water vapor permeability, an oxygen permeability, and the like. The water vapor permeability per day in accordance with the JIS K7129 B method is preferably, for example, 10 g/m² or less, although the lower the better. The oxygen permeability per day in accordance with JIS K7126-2 is preferably, for example, 1 cm³/m²·atm or less, although the lower the better.

The gas barrier member has, starting from the one electrode side, a metal layer and a base (this is distinguished from the base that constitutes the photoelectric conversion device described before; so, this may be referred to as the "sealing base") in sequence. The gas barrier member having the metal layer may cause an electrical malfunction in the photoelectric conversion device to be manufactured, as described later, but the electrical malfunction can be suppressed by using the structure according to the present invention. The term "in sequence" means that the metal layer and the base may be arranged in the above order as a whole; so, other members or layers may be inserted between the metal layer and the base.

The metal layer means a thin metal film. Illustrative examples thereof include a thin film formed of a metal such as aluminum, copper, silver, gold, platinum, and nickel, while a thin film formed of aluminum is preferable.

The base is a member that supports each layer (metal layer, insulating layer, and the like) that constitutes the sealing member. In addition, from a viewpoint to widen the application thereof, it is preferable that the base have high flexibility. Illustrative examples of the base material include resin films of polyesters such as polyethylene terephthalate (PET), a polycarbonate, a polyimide, a polymethyl methacrylate, a polysulfone, and a polyether ether ketone, as well as a thin glass film (glass having the thickness of 200 um or less). Among these materials, from viewpoints of easy production and cost, resin films of a polyester and of a polyimide, as well as a thin glass film are preferable. When the resin film or the thin glass film is used as the base, the thickness of the base is preferably 200 um or less. When the base has the thickness of 200 um or less, the flexibility thereof is enhanced so that the durability thereof can be improved as well, even when the photoelectric conversion device is bent. The thickness of the base can be measured by a publicly known method, for example, using a contact-type thickness gauge.

As described above, the adhesive member has the function of enabling the sealing member to be bonded to other member; it also has the function as an insulating layer that prevents an electrical connection between the one electrode and the metal layer in the gas barrier layer. Therefore, in the description in the present disclosure, the adhesive member is also referred to as the insulating layer. However, this does not exclude the case where the adhesive member and the insulating layer are used as separate components.

In the adhesive member (insulating layer), for example, a general material used for sealing of an organic electroluminescence device, an organic transistor, and the like can be used as the material thereof. Specifically, illustrative examples thereof include a pressure-sensitive adhesive resin, a thermosetting resin, a thermoplastic resin, and a photo-curable resin. Among these, the pressure-sensitive adhesive resin, which does not require heating at the sealing process, is preferable. On the other hand, when the pressure-sensitive adhesive resin is used, as it will be described below, an electrical malfunction may occur in the produced photoelectric conversion device, because it is necessary to bond the sealing member to other member by applying a pressure when forming the photoelectric conversion device; but the malfunction can be suppressed by using the composition of the present invention. Specific examples of the material for the adhesive member include an ethylene-vinyl acetate copolymer resin, a styrene-isobutylene resin, a hydrocarbon-based resin, an epoxy-based resin, a polyester-based resin, an acrylic-based resin, a urethane-based resin, and a silicone-based resin. Variety of adhesive properties can be obtained by chemical modification of a main chain, a branched chain, and a terminal of these resins, as well as by adjusting the molecular weight thereof, and the like.

### UV-cut Layer

The "UV-cut layer" is the layer that is arranged on the incident surface side and that suppresses deterioration of the photoelectric conversion device due to a UV light. It is preferable that the UV-cut layer be a film-like member that absorbs a UV light. The UV-cut layer is preferably arranged on the base located on the incident surface side.

In general, the function required for the UV-cut layer is expressed in terms of light transmittance, and the like. The light transmittance at a wavelength of 370 nm or less is preferably less than 1%, for example. In addition, the light transmittance at a wavelength of 410 nm or less is preferably less than 1%, for example.

### Gas Barrier Layer

The "gas barrier layer" is the layer that prevents external substances such as water and oxygen from penetrating into the photoelectric conversion device. The gas barrier layer is preferably a continuous film. The gas barrier layer is arranged preferably adjacent to the base (device base), while more preferably between the other electrode and the base. Note that when the gas barrier layer is arranged adjacent to the base, the gas barrier layer is regarded as one component that constitutes the base (device base) in the present disclosure.

The function required for the gas barrier layer is generally expressed in terms of a water vapor permeability, an oxygen permeability, and the like. The water vapor permeability per day in accordance with the JIS K7129 B method is preferably, for example, 10 g/m² or less, although the lower the better. The oxygen permeability per day in accordance with JIS K7126-2 is preferably, for example, 1 cm³/m²·atm or less, although the lower the better.

Illustrative examples of the material for the gas barrier layer include the materials including SiO₂, SiNx, Al₂O₃, SiC, SiCN, SiOC, and SiOAl, as well as a siloxane-based material.

### Other Layers

The photoelectric conversion device may further have other layers such as an insulating porous layer, a degradation prevention layer, and a protection layer, as needed.

### Configuration of Photoelectric Conversion Device Relating to Organic Thin Film Solar Cell

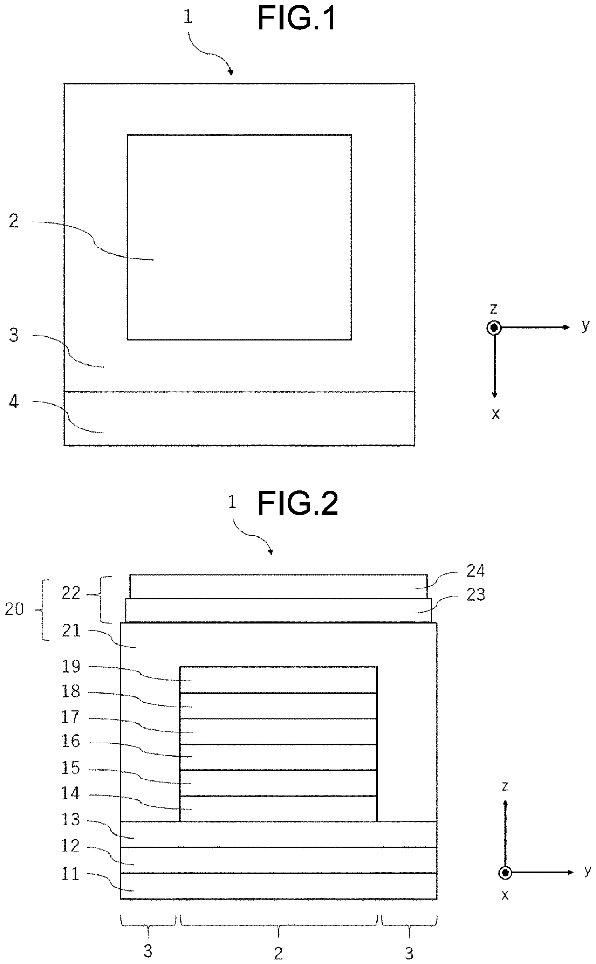

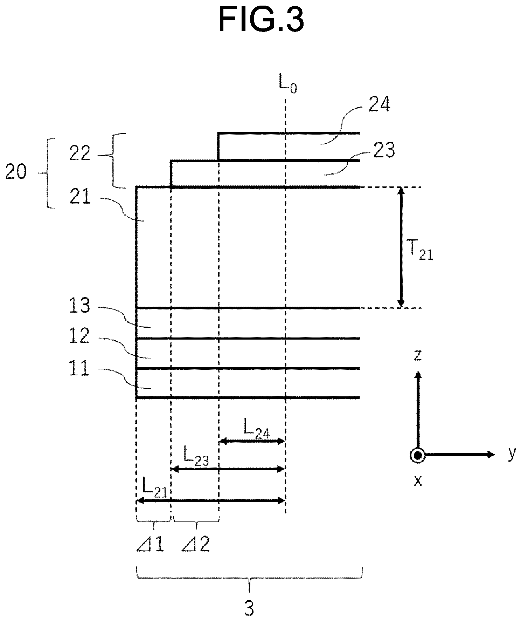

One configuration example of the photoelectric conversion device will be described with referring to FIGS. 1 to 3. FIG. 1 is an overlooking schematic view of one example illustrating the photoelectric conversion device. FIG. 2 is a sectional schematic view of one example illustrating the photoelectric conversion device. FIG. 3 is a sectional schematic view of the photoelectric conversion device illustrated in FIG. 2, having the sealing zone in the left end thereof enlarged.

As illustrated in the overlooking schematic view in FIG. 1, a photoelectric conversion device 1 has a photoelectric conversion zone 2, which is the zone capable of performing the photoelectric conversion, a sealing zone 3 surrounding the photoelectric conversion zone 2, and other zone 4 where other members such as a terminal are arranged.

As illustrated in the sectional schematic view in FIG. 2, in the photoelectric conversion zone 2, the photoelectric conversion device 1 has a stacked structure consisting of, sequentially from the incident surface side along the stacking direction z, a UV-cut layer 11, a base (device base) 12, a first electrode 13, a first electron transport layer 14, a second electron transport layer (intermediate layer) 15, a photoelectric conversion layer 16, a hole transport layer 17, a second electrode 18, a surface protection portion (passivation layer) 19, and a sealing member 20 (hereinafter, this structure is also referred to as "Structure A"). In the sealing zone 3, the photoelectric conversion device 1 has a stacked structure consisting of, sequentially from the incident surface side along the stacking direction z, the UV-cut layer 11, the base (device base) 12, the first electrode 13, and the sealing member 20. At this time, the sealing member 20 has an adhesive member (insulating layer) 21 and a gas barrier member 22, and the gas barrier member 22 has a metal layer 23 and a base (sealing base) 24. The sealing member 20 encapsulates the first electron transport layer 14, the second electron transport layer (intermediate layer) 15, the photoelectric conversion layer 16, the hole transport layer 17, the second electrode 18, and the surface protection portion (passivation layer) 19, and is bonded to the surface protection portion (passivation layer) 19 and the sealing zone 3 in the first electrode 13. Note that, in the photoelectric conversion device 1, the first electrode 13 corresponds to the "other electrode" described above, and the second electrode 18 corresponds to the "one electrode" described above. The photoelectric conversion device 1 may further have a connecting portion or the like to electrically connect in series or in parallel with other photoelectric conversion device. The stacking direction z represents the direction perpendicular to the surface (xy surface) of each layer in the photoelectric conversion device. The direction included in the surface (xy-surface) of each layer in the photoelectric conversion device denotes the surface direction.

The stacking order from the first electrode 13 to the second electrode 18 in the photoelectric conversion zone 2 of the photoelectric conversion device 1 having the structure A is not limited to the order as described above. Specifically, in the photoelectric conversion zone 2, the photoelectric conversion device 1 may have a stacked structure consisting of, sequentially from the incident surface side along the stacking direction z, the UV-cut layer 11, the base (device base) 12, the second electrode 13, the hole transport layer 14, the photoelectric conversion layer 15, the second electron transport layer (intermediate layer) 16, the first electron transport layer 17, the first electrode 18, the surface protection portion (passivation layer) 19, and a sealing member 20 (hereinafter, this structure is also referred to as "Structure B"). At this time, the sealing member 20 encapsulates the hole transport layer 14, the photoelectric conversion layer 15, the second electron transport layer (intermediate layer) 16, the first electron transport layer 17, the first electrode 18, and the surface protection portion (passivation layer) 19, and is bonded to the surface protection portion (passivation layer) 19 and the sealing zone 3 in the second electrode 13. Note that, in the photoelectric conversion device 1, the second electrode 13 corresponds to the "other electrode" described above, and the first electrode 18 corresponds to the "one electrode" described above.

In the present disclosure, as illustrated in FIGS. 1 and 2, the photoelectric conversion device having the structure A is mainly described as one example, but a person skilled in the art can easily understand from this description about the photoelectric conversion device having the structure B.

Next, by using the sectional schematic diagram in FIG. 3, the relationship among the adhesive member (insulating layer) 21, the metal layer 23, and the base (sealing base) 24 will be explained. FIG. 3 is a sectional schematic view of the photoelectric conversion device 1 illustrated in FIG. 2, having the sealing zone 3 in the left end thereof enlarged. Here, the photoelectric conversion zone 2 is omitted from the drawing. As illustrated in FIG. 3, the end in the surface direction of the photoelectric conversion device has the structure composed of, sequentially from the incident surface side along the stacking direction z, the UV-cut layer 11, the base (device base) 12, the first electrode 13 which is the other electrode, the adhesive member (insulating layer) 21, the metal layer 23, and the base (sealing base) 24. Further, as illustrated in FIG. 3, in the end of the sealing member 20 in the surface direction, the length of the adhesive member (insulating layer) 21 in the surface direction is equal to or longer than the length of the metal layer 23 in the surface direction, and the length of the metal layer 23 in the surface direction is longer than the length of the base (sealing base) 24 in the surface direction.

In the end of the sealing member 20 in the surface direction, that the length of the adhesive member (insulating layer) 21 in the surface direction is equal to or longer than the length of the metal layer 23 in the lane direction, and that the length of the metal layer 23 in the surface direction is longer than the length of the base (sealing base) 24 in the surface direction can be determined, for example, in the way as described below. First, in the same way as in FIG. 3, in the photoelectric conversion device, a section including the stacking direction z is formed. Next, among the adhesive member (insulating layer) 21, the metal layer 23, and the base (sealing base) 24, from the end that protrudes most in the surface direction of the sealing member 20, a position about 3 to 5 times inside the sum of the thicknesses of the adhesive member (insulating layer) 21, the metal layer 23, and the base (sealing base) 24 is determined, then, a reference line L₀ that passes through the said position and that is in parallel with the stacking direction z is determined (provided that among the adhesive member (insulating layer) 21, the metal layer 23, and the base (sealing base) 24, the reference line L₀ needs to be inside the end that does not protrude most in the surface direction of the sealing member 20). Next, the maximum length L₂₁ between the reference line L₀ and the end of the adhesive member (insulating layer) 21 in the surface direction, the maximum length L₂₃ between the reference line L₀ and the end of the metal layer 23 in the surface direction, and the maximum length L₂₄ between the reference line L₀ and the end of the base (sealing base) 24 in the surface direction, respectively, are measured. Next, the measurement position is changed by forming another section, or the like; then, the lengths L₂₁, L₂₃, and L₂₄, each are measured three or more times, and the average values for each are adopted. When the length L₂₁ is equal to the length L₂₃, or when the length L₂₁ is longer than the length L₂₃, the length of the adhesive member (insulating layer) 21 in the surface direction is judged to be equal to or longer than the length of the metal layer 23 in the surface direction at the end of the sealing member 20 in the surface direction. Similarly, when the length L₂₃ is longer than the length L₂₄, the length of the metal layer 23 in the surface direction is judged to be longer than the length of the base (sealing base) 24 in the surface direction at the end of the sealing member 20 in the surface direction. In the present disclosure, the difference between the length L₂₁ and the length L₂₃ is denoted as Δ1, and the difference between the length L₂₃ and the length L₂₄ is denoted as Δ2. The section can be observed by using an electron microscope or the like.

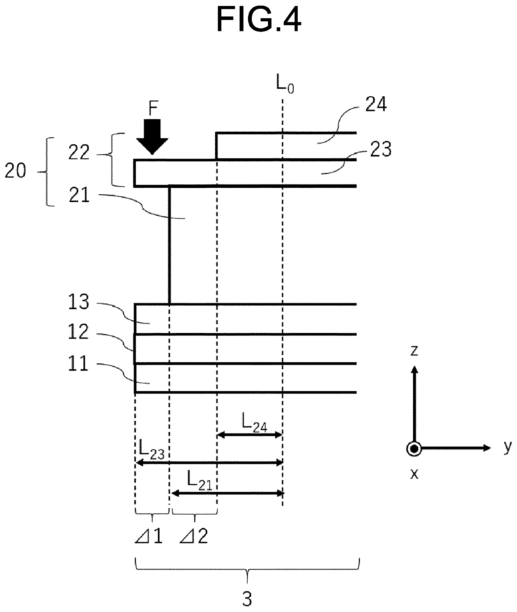

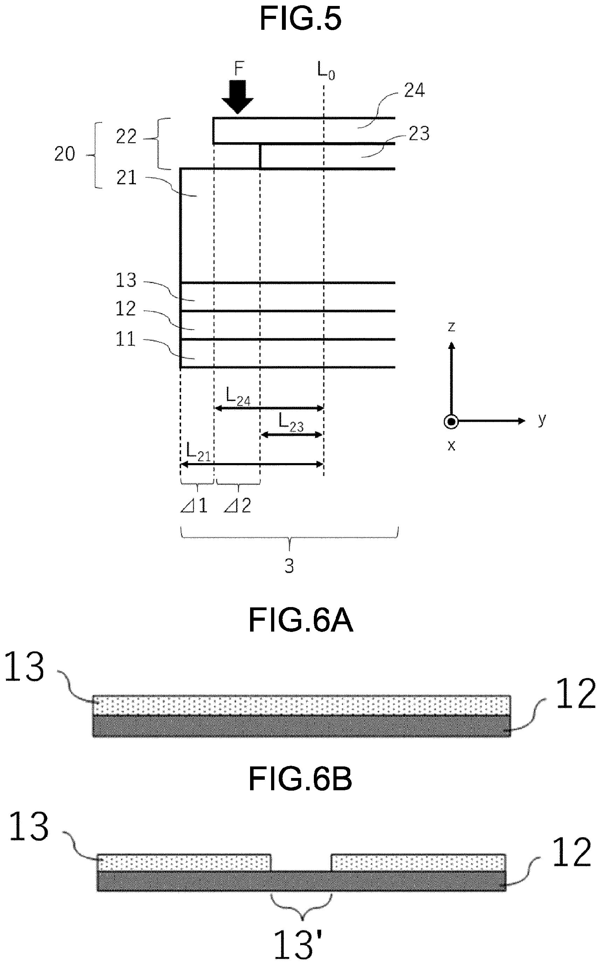

Next, the reason why the configuration in which the length of the adhesive member (insulating layer) 21 in the surface direction is equal to or longer than the length of the metal layer 23 in the surface direction and the length of the metal layer 23 in the surface direction is longer than the length of the base (sealing base) 24 in the surface direction is advantageous will be explained by using the configuration illustrated in FIG. 3, which is included in the present invention, and the configurations illustrated in FIGS. 4 and 5, which are not included in the present invention. FIG. 4 is an enlarged sectional schematic view of the sealing zone of the photoelectric conversion device not included in the present invention. FIG. 5 is an enlarged sectional schematic view of the sealing zone of the photoelectric conversion device not included in the present invention.

As illustrated in FIG. 4, when the length of the metal layer 23 in the surface direction of the sealing member 20 is longer than the length of the adhesive member (insulating layer) 21 in the surface direction, a pressure may be applied to the photoelectric conversion device during manufacturing, use, or the like thereof. At this time, as illustrated in FIG. 4, when a pressure F is applied to the left end of the metal layer 23, the metal layer 23 deforms in the direction (in the negative direction of the stacking direction z) to the other electrode, which is the first electrode 13, so that the metal layer 23 and the other electrode, the first electrode 13, can approach or contact with each other. When the metal layer 23 and the other electrode, i.e., the first electrode 13, approach or contact with each other, there is a problem of an electrical malfunction (for example, short circuit) in the photoelectric conversion device.

Also, as illustrated in FIG. 5, when the length of the base (sealing base) 24 in the surface direction of the sealing member 20 is longer than the length of the metal layer 23 in the surface direction, a pressure may be applied to the photoelectric conversion device during manufacturing, use, or the like thereof. At this time, as illustrated in FIG. 5, when the pressure F is applied to the left end of the base (sealing base) 24, the pressure applied to the base (sealing base) 24 is also applied to the left end of the metal layer 23, then, the left end of the metal layer 23 deforms in such a way as to submerge into the adhesive member (insulating layer) 21 to the direction (negative direction in the stacking direction z) of the other electrode, i.e., the first electrode 13, so that the metal layer 23 and the other electrode, i.e., the first electrode 13, can approach or contact with each other. When the metal layer 23 and the other electrode, i.e., the first electrode 13, approach or contact with each other, there is a problem of an electrical malfunction (for example, short circuit) in the photoelectric conversion device.

In contrast, as illustrated in FIG. 3, the length of the adhesive member (insulating layer) 21 in the surface direction of the sealing member 20 is equal to or longer than the length of the metal layer 23 in the surface direction, so that even when the pressure is applied during manufacture or use of the photoelectric conversion device, the deformation of the metal layer 23 to the direction (negative direction of the stacking direction z) of the other electrode, i.e., the first electrode 13, is suppressed; as a result, the photoelectric conversion device having the occurrence of the electrical malfunction suppressed can be provided. In addition, as illustrated in FIG. 3, the length of the metal layer 23 in the surface direction of the sealing member 20 is longer than the length of the base (sealing base) 24 in the surface direction, so that even when the pressure is applied to the base (sealing base) 24 during the manufacture, the use, or the like of the photoelectric conversion device, transmission of the pressure applied to the base (sealing base) 24 to the left end of the metal layer 23 is suppressed. Accordingly, the deformation of the left end of the metal layer 23 to the direction (negative direction of the stacking direction z) of the other electrode, i.e., the first electrode 13, in such a way as to submerge into the adhesive member (insulating layer) 21 is suppressed; as a result, the photoelectric conversion device having the occurrence of the electrical malfunction suppressed can be provided.

One example of the case in which the pressure is applied during the manufacturing of the photoelectric conversion device described above is when the material that constitutes the adhesive member (insulating layer) 21 is a pressure-sensitive adhesive resin so that the pressure is required upon bonding the sealing member 20 to the other members to form the photoelectric conversion device.

Note that, an electrical malfunction (such as a short circuit) in the photoelectric conversion device is caused by approaching or contacting between the metal layer 23 and the other electrode, i.e., the first electrode 13, as described above. In other words, the closer the metal layer 23 and the other electrode, i.e., the first electrode 13, are located, the more likely the electrical malfunction (such as a short circuit) can occur. Accordingly, in the case where the photoelectric conversion device has such a configuration, the configuration according to the present invention is still more effective.

One example of the case where the metal layer 23 and the other electrode, i.e., the first electrode 13, are in a close proximity is illustrated in FIG. 3, in which at the end in the surface direction of the photoelectric conversion device, this is composed of, along the stacking direction z, the first electrode 13, i.e., the other electrode, the adhesive member (insulating layer) 21, the metal layer 23, and the base (sealing base) 24 in sequence; in other words, the other electrode, i.e., the first electrode 13, and the metal layer 23 are adjacent to each other via the adhesive member (insulating layer) 21.

Another example of the case where the metal layer 23 and the other electrode, i.e., the first electrode 13, are in close proximity is a case when the layer thickness of the adhesive member (insulating layer) 21 (T₂₁ in FIG. 3) is small at the end in the surface direction of the sealing member 20. The layer thickness of the adhesive member (insulating layer) 21 (T₂₁) can be made, for example, 50.0 um or less.

As described above, the length of the adhesive member (insulating layer) 21 in the surface direction of the sealing member 20 is equal to or longer than the length of the metal layer 23 in the surface direction (the length L₂₁ is equal to or longer than the length L₂₃); specifically, Δ1, which represents the degree of protrusion (difference between the length L₂₁ and the length L₂₃), is 0 um or more and preferably 20 um or less, and0 um or more and more preferably 10 µm or less, and 0 µm or more and still more preferably 5 µm or less. The above range enables to provide the photoelectric conversion device having occurrence of the electrical malfunction suppressed furthermore.

As described above, in the surface direction of the sealing member 20, the length of the metal layer 23 in the surface direction is longer than the length of the base (sealing base) 24 in the surface direction (the length L₂₃ is longer than the length L₂₄); specifically, Δ2 (difference between the length L₂₃ and the length L₂₄), which represents the degree of protrusion, is 0.1 µm or more, preferably 0.5 µm or more, and more preferably 0.9 µm or more, while especially preferably 1.0 µm or more. Also, Δ2 is preferably 20 µm or less, while more preferably 10 µm or less. The above range enables to provide the photoelectric conversion device having occurrence of the electrical malfunction suppressed furthermore.

### Photoelectric Conversion Module Relating to Organic Thin Film Solar Cell

A "photoelectric conversion module" is the module that has a plurality of the photoelectric conversion devices that are electrically connected. The electrical connection may be made in such a way as to connect the photoelectric conversion devices either in series or in parallel. The photoelectric conversion module may have both a plurality of the photoelectric conversion devices connected in series and a plurality of the photoelectric conversion devices connected in parallel. All the "connections" in the present disclosure shall not be limited to a physical connection, but shall also include an electrical connection.

The photoelectric conversion module has a plurality of the photoelectric conversion devices, a connecting portion that electrically connects the photoelectric conversion devices, and other members as needed. In other words, the photoelectric conversion module has at least a first photoelectric conversion device, a second photoelectric conversion device that is adjacent to the first photoelectric conversion device, a connecting portion that electrically connects the first photoelectric conversion device with the second photoelectric conversion device, and with other members as needed. The photoelectric conversion device and the connecting portion may be different only in the functions between them; so, the photoelectric conversion device and the connecting portion may be independent members to each other, or the photoelectric conversion device and the connecting portion may be continuous members or one integrated member. For example, the electrode, which is one member of the photoelectric conversion device, and the connecting portion may be the independent members to each other, or they may be the continuous members or one integrated member.

### Method for Manufacturing Photoelectric Conversion Device and Photoelectric Conversion Module, Relating to Organic Thin Film Solar Cell

Hereinafter, one example of the manufacturing method of the photoelectric conversion module will be described, which also means that one example of the manufacturing method of the photoelectric conversion device will be described simultaneously. In the present disclosure, one example of the manufacturing method of the photoelectric conversion device having the structure A as illustrated in FIG. 2 will be described. However, from such description, a person skilled in the art can easily understand one example of the manufacturing method of the photoelectric conversion device having the structure B.

The method for manufacturing the photoelectric conversion module having the photoelectric conversion device includes, for example, a gas barrier layer forming process at which a gas barrier layer is formed on a base, a first electrode forming process at which a first electrode is formed on the base having the gas barrier layer, an electron transport layer forming process at which an electron transport layer is formed on the first electrode, a photoelectric conversion layer forming process at which a photoelectric conversion layer is formed on the electron transport layer, a penetrating portion forming process at which a penetrating portion that penetrates through the electron transport layer and the photoelectric conversion layer is formed, a hole transport layer forming process at which a hole transport layer is formed on the photoelectric conversion layer, and exposed surfaces of the first electrode, of the electron transport layer, and of the photoelectric conversion layer are covered with a material of the hole transport layer, a second electrode forming process at which a second electrode is formed on the hole transport layer, and the penetrating portion is filled by a material of the second electrode to form a penetrating structure, a surface protection portion forming process at which a surface protection portion is formed on the second electrode, a sealing zone forming process at which a sealing zone is formed on the first electrode by removing an outer periphery in the stacked materials from the electron transport layer to the surface protection portion, a sealing member forming process at which the sealing member is caused to encapsulate the stacked materials from the electron transport layer to the surface protection portion thereby adhering the surface protection portion with the sealing zone, a sealing member shaping process at which the insulating layer, the metal layer, and the base (sealing base) at the end in the surface direction of the sealing member are shaped in such a way as to give the above-mentioned shape, and other processes such as a UV-cut layer forming process, as needed.

### Gas Barrier Layer Forming Process

The method for manufacturing the photoelectric conversion module having the photoelectric conversion device preferably has a gas barrier layer forming process at which a gas barrier layer is formed on the base. When the base itself has the gas barrier property, it is not necessary to form the gas barrier layer.

### First Electrode Forming Process

The method for manufacturing the photoelectric conversion module having the photoelectric conversion device preferably has a first electrode forming process at which a first electrode is formed on the base having the gas barrier layer. When the base does not have the gas barrier layer, the first electrode may be formed on the base.

The method for forming the first electrode has already described in the description about the first electrode.

### Electron Transport Layer Forming Process

The method for manufacturing the photoelectric conversion module having the photoelectric conversion device preferably has an electron transport layer forming process at which an electron transport layer is formed on the first electrode. When the electron transport layer has the first electron transport layer and a second electron transport layer (intermediate layer) as the electron transport layer, it is preferable that the electron transport layer forming process have the first electron transport layer forming process to form the first electron transport layer on the first electrode and the second electron transport layer forming process to form the second electron transport layer on the first electron transport layer.

The method for forming the electron transport layer has already been described in the description of the electron transport layer.

### Photoelectric Conversion Layer Forming Process

The method for manufacturing the photoelectric conversion module having the photoelectric conversion device preferably has a photoelectric conversion layer forming process at which a photoelectric conversion layer is formed on the electron transport layer.

The method for forming the photoelectric conversion layer has already been described in the description about the photoelectric conversion layer.

### Penetrating Portion Forming Process

The method for manufacturing the photoelectric conversion module having the photoelectric conversion device preferably has a penetrating portion forming process at which a through hole that penetrates through the electron transport layer and the photoelectric conversion layer is formed. In the present disclosure, the penetrating portion represents a vacant hole, and in the case of the photoelectric conversion device having the structure A as illustrated in FIG. 2, this represents the vacant hole that penetrates through the electron transport layer and the photoelectric conversion layer. The shape, the size, and the like of the penetrating portion are not restricted as far as this can electrically connect among the photoelectric conversion devices; so, this may be, for example, a line or a circular shape when the photoelectric conversion module is viewed in the plane from the second electrode side, and a rectangular or a square shape when the section of the photoelectric conversion device is observed. Each layer is divided by this penetrating portion to form a plurality of the photoelectric conversion devices.

Examples of the method for forming the penetrating portion include a laser deletion and a mechanical scribing.

### Hole Transport Layer Forming Process

The method for manufacturing the photoelectric conversion module having the photoelectric conversion device preferably has a hole transport layer forming process at which a hole transport layer is formed on the photoelectric conversion layer, and the exposed surfaces of the first electrode, of the electron transport layer, and of the photoelectric conversion layer in the penetrating portion are covered with a material of the hole transport layer.

The method for forming the hole transport layer has already been described in the description about the hole transport layer.

### Second Electrode Forming Process

The method for manufacturing the photoelectric conversion module having the photoelectric conversion device preferably has a second electrode forming process at which a second electrode is formed on the hole transport layer, and the penetrating portion is filled with the material of the second electrode to form a penetrating structure. In the present disclosure, the penetrating structure represents the structural body that fills the interior of the penetrating portion, and in the case of the photoelectric conversion module having the structure A as illustrated in FIG. 2, this represents the structural body formed of the material of the hole transport layer and the material of the second electrode. This penetrating portion functions as the connecting portion among the photoelectric conversion devices.

The method for forming the second electrode has already been described in the description about the second electrode.

### Surface Protection Portion Forming Process

The method for manufacturing the photoelectric conversion module having the photoelectric conversion device preferably has a surface protection portion forming process at which a surface protection portion is formed on the second electrode.

The method for forming the surface protection portion has already been described in the description about the surface protection portion.

### Sealing Zone Forming Process

The method for manufacturing the photoelectric conversion module having the photoelectric conversion device preferably has a sealing zone forming process at which a sealing zone is formed on the first electrode by removing an outer periphery in the stacked materials from the electron transport layer to the surface protection portion (the electron transport layer, the photoelectric conversion layer, the hole transport layer, the second electrode, and the surface protection portion) thereby exposing the first electrode.

Examples of the method for removing the outer periphery include a laser deletion and a mechanical scribing.

### Sealing Member Forming Process

The method for manufacturing the photoelectric conversion module having the photoelectric conversion device may have an sealing member forming process at which the sealing member is caused to encapsulate the various stacked materials (stacked materials of the electron transport layer, the photoelectric conversion layer, the hole transport layer, the second electrode, and the surface protection portion), and the surface protection portion and the sealing zone are contacted so as to be adhered with each other. The sealing member forming process may also be carried out by applying an adhesive member followed by affixing the gas barrier member onto the adhesive member, or by affixing the adhesive member that has been previously applied to the gas barrier member.

Although the sealing member encapsulates the stacked layers in the photoelectric conversion device as explained in this manufacturing method, an embodiment may be allowed as well in which the sealing member encapsulates the photoelectric conversion module; thus, as a result, the stacked layers in the photoelectric conversion device are encapsulated. In other words, this process is not limited to the embodiment in which the stacked layers in each photoelectric conversion device are encapsulated.

### Sealing Member Shaping Process

In the method for manufacturing the photoelectric conversion module having the photoelectric conversion device, the insulating member is shaped in such a way that, at the end of the sealing member in the surface direction, the length of the insulating layer in the surface direction is equal to or longer than the length of the metal layer in the surface direction, and the length of the metal layer in the surface direction is longer than the length of the base (sealing base) in the surface direction by 0.1 um or more.

Examples of the method for shaping the sealing members to the above-described shape include a laser deletion and a mechanical scribing. This shaping may be carried out before or after bonding the sealing member to other members.

### UV-cut Layer Forming Process

The manufacturing method of the photoelectric conversion module having the photoelectric conversion device may, as needed, have a UV-cut layer forming process to form a UV-cut layer on the incident surface side.

### Other Processes

The manufacturing method of the photoelectric conversion module having the photoelectric conversion device may have an insulating porous layer forming process, a deterioration preventive layer forming process, a protection layer forming process, and the like, as needed.

### Specific Examples of Manufacturing Method of Photoelectric Conversion Device and Photoelectric Conversion Module, Relating to Organic Thin Film Solar Cell

FIGS. 6A to 6M are used to describe in detail one example of the method for manufacturing the photoelectric conversion module having the photoelectric conversion device. FIGS. 6A to 6M are schematic views of one example illustrating the manufacturing method of the photoelectric conversion module.

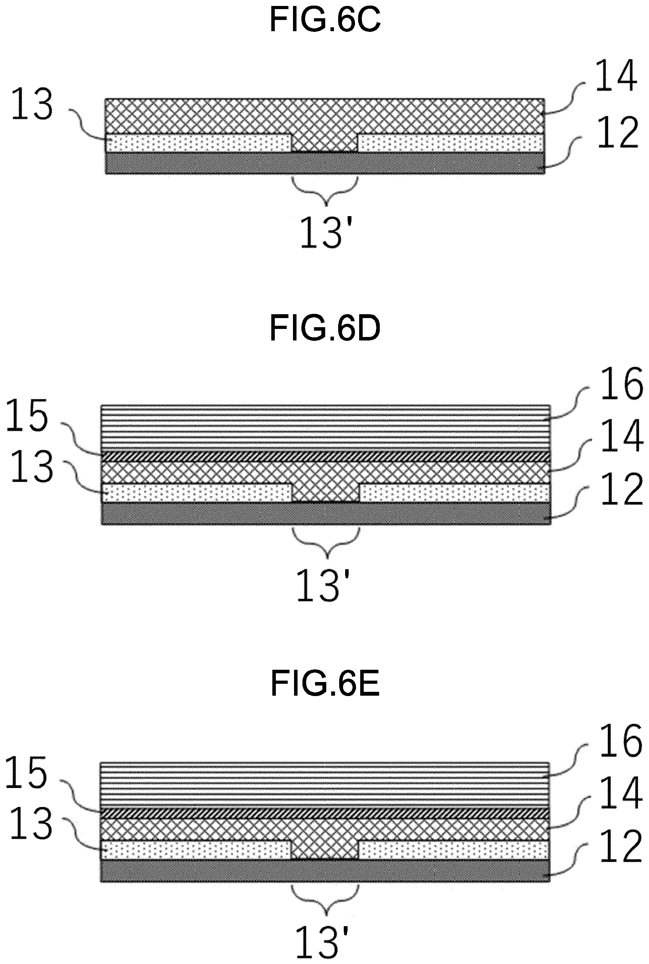

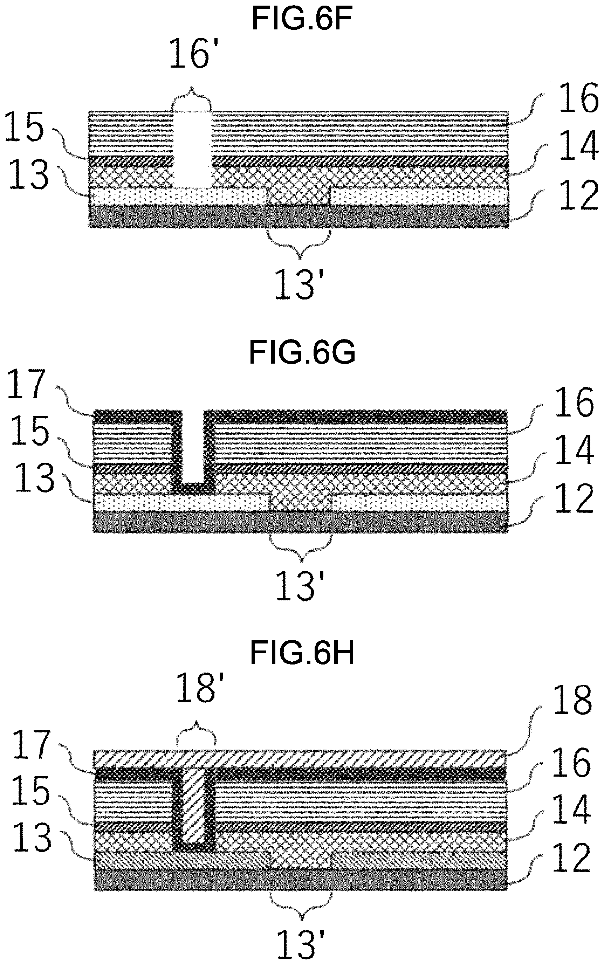

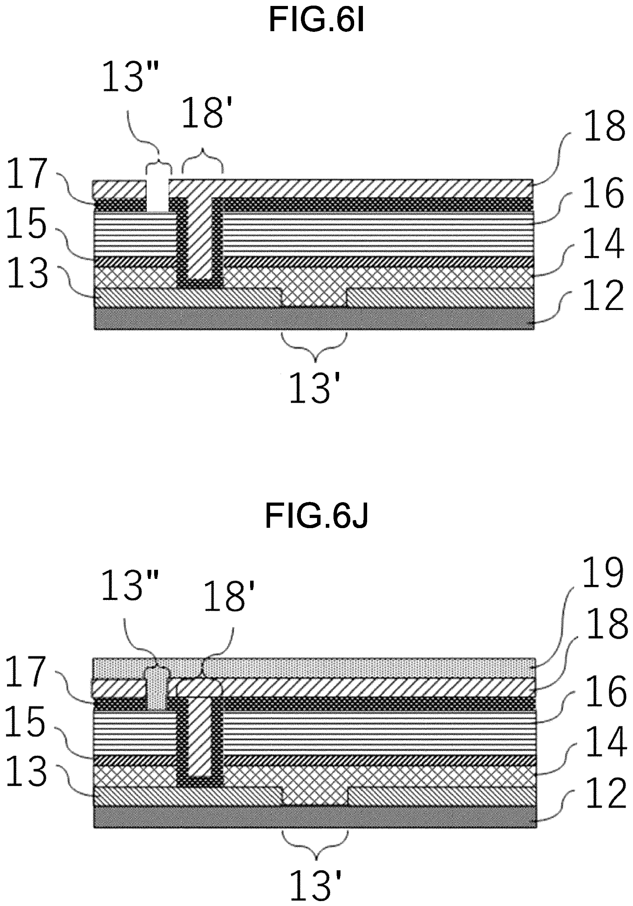

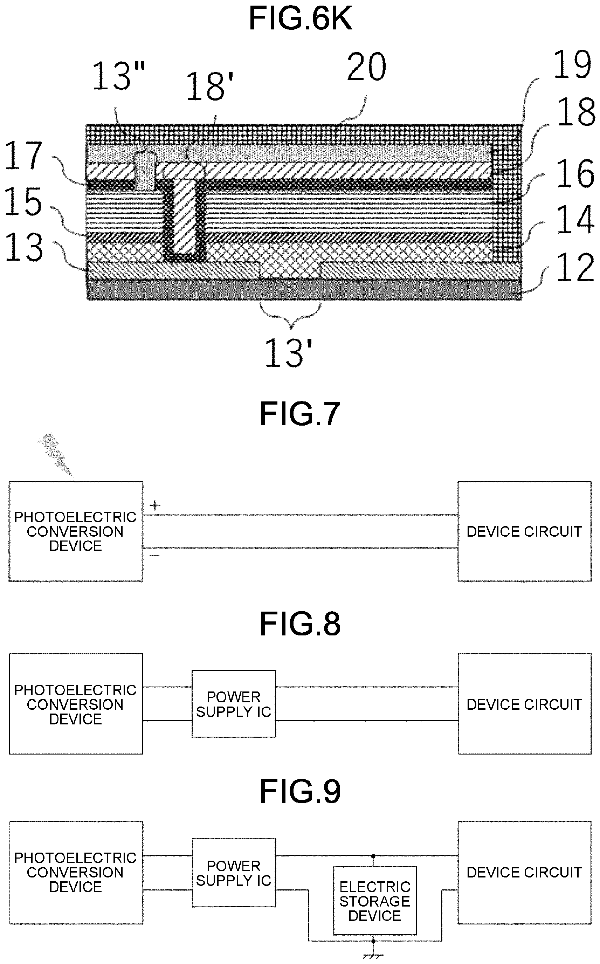

As illustrated in FIG. 6A, first, a first electrode 13 (the other electrode) is formed on a base 12 having a gas barrier property. When forming a plurality of the photoelectric conversion devices on one base 12, as illustrated in FIG. 6B, a part of the formed first electrode 13 is made to disappear to form a first dividing portion 13'. The photoelectric conversion device that is going to be formed on the left side of the dividing portion 13' is referred to as a first photoelectric conversion device, and the photoelectric conversion device that is going to be formed on the right side of the dividing portion 13' is referred to as a second photoelectric conversion device. Next, as illustrated in FIGS. 6C and 6D, a first electron transport layer 14 and a second electron transport layer (intermediate layer) 15 are formed on the base 12 and the first electrode 13. Next, a photoelectric conversion layer 16 is formed on the second electron transport layer 15 thus formed, as illustrated in FIG. 6E. After forming the photoelectric conversion layer 16, as illustrated in FIG. 6F, predetermined areas of the first electron transport layer 14, the second electron transport layer 15, and the photoelectric conversion layer 16, these being formed on the first electrode 13, are removed to form a penetrating portion 16'. After forming the penetrating portion 16', a hole transport layer 17 and a second electrode 18 are formed as illustrated in FIGS. 6G and 6H. With formation of the hole transport layer 17 and the second electrode 18, a connecting portion 18', which is the structural body made of the material of the hole transport layer and the material of the second electrode, is formed in the penetrating portion 16'. When forming a plurality of the photoelectric conversion devices on one base 12, as illustrated in FIG. 6I, a predetermined area between the second electrode 18 (one electrode) in the first photoelectric conversion device and the second electrode 18 (one electrode) in the second photoelectric conversion device is removed in such a way as to penetrate the second electrode 18 and the hole transport layer 17 to form a second dividing portion 13''. Next, as illustrated in FIG. 6J, a surface protection portion 19 is formed on the second electrode 18. At this time, with formation of the surface protection portion 19, a structural body containing the material that constitutes the surface protection portion (assuming that this structural body is also a component of the dividing portion) is formed in the second divided portion 13''. This structural body (dividing portion) is continuous with each surface protection portion 19 in the first photoelectric conversion device and the second photoelectric conversion device, as illustrated in FIG. 6J. The structural body described above (division part) is in contact with the side surface of each second electrode 18 (one electrode) in the first photoelectric conversion device and the second photoelectric conversion device, the side surface of each hole transport layer 17 in the first photoelectric conversion device and the second photoelectric conversion device, and the photoelectric conversion layer 16, as illustrated in FIG. 6J. Because the structural body (dividing portion), which has the same material as the material that constitutes the surface protection portion, is in contact with and covers the sides as well as the photoelectric conversion layer, the contact of water or oxygen that penetrates from the outside with each layer of the photoelectric conversion layer and the like can be suppressed; thus, corrosion, deterioration, and the like that occur over time in each layer of the photoelectric conversion layer and the like can be suppressed, thereby enhancing the storage durability thereof. Next, as illustrated in FIG. 6K, the first electrode 13 is exposed by removing the outer periphery of the stacked layers from the electron transport layer 14 to the surface protection portion 19 to form the sealing zone on the first electrode 13; and furthermore, the stacked layers from the electron transport layer to the surface protection portion are encapsulated by the sealing member 20, and also the surface protection portion and the sealing zone are adhered by bringing them into contact to each other. Next, the sealing member is shaped in such a way that the insulating layer, the metal layer, and the base become the above-described shape at the end of the sealing member 20 in the surface direction.

### Photoelectric Conversion Device Relating to Dye-sensitized Solar Cell

As one example other than the photoelectric conversion device relating to the organic thin film solar cell described above, the photoelectric conversion device relating to a dye-sensitized solar cell will be described.

The photoelectric conversion device has at least a first electrode, a photoelectric conversion layer, and a second electrode in sequence. Also, the photoelectric conversion layer has an electron transport portion, a photosensitizing compound, and a hole transport portion.

In addition, the photoelectric conversion device may have a surface protection portion. The surface protection portion is arranged adjacent to the surface of one electrode that is selected from the first electrode and the second electrode and that is not facing the photoelectric conversion layer.

In addition, the photoelectric conversion device has a sealing member. The sealing member is arranged preferably adjacent to the surface protection portion, and encapsulates the surface protection portion, one electrode, and the photoelectric conversion layer.

In addition, the photoelectric conversion device has a base (device base) and the like, as needed. The base (device base) is preferably arranged adjacent to the other electrode on the side not facing the photoelectric conversion layer of the other electrode.

In other words, as one example, the photoelectric conversion device has a configuration in which the base (device base), the first electrode, the photoelectric conversion layer, the second electrode, the surface protection portion, and the sealing member are sequentially stacked. In the following, each component will be described. However, the description about the base (device base), the first electrode, the second electrode, the surface protection portion, and the sealing member will be omitted because in these the same components as those in the photoelectric conversion device for the organic thin film solar cell described above can be used.

### Photoelectric Conversion Layer

The photoelectric conversion layer has an electron transport portion that transports an electron, a photosensitizing compound that absorbs light and generates an electric charge, and a hole transport portion that transports a hole.

### Electron Transport Portion

The electron transport portion transports an electron generated by the photosensitizing compound.

The electron transport portion contains an electron transportable material, and other materials as needed. There is no particular restriction in the electron transportable material; this can be selected as appropriate in accordance with the purpose, while a semiconductor material is preferable. The semiconductor material has a particulate shape, and is preferable to form a porous membrane by bonding with each other. A photosensitizing compound is chemically or physically adsorbed onto the surface of the semiconductor particles that make up the porous electron transport portion.

There is no particular restriction in the semiconductor material; so, any publicly known materials may be used, such as a single semiconductor, a compound semiconductor, and a compound having a perovskite structure.

Examples of the single semiconductor include silicon and germanium.

Illustrative examples of the compound semiconductor include metal chalcogenide, including specifically oxides of titanium, tin, zinc, iron, tungsten, zirconium, hafnium, strontium, indium, cerium, yttrium, lanthanum, vanadium, niobium, and tantalum; sulfides of cadmium, zinc, lead, silver, antimony, and bismuth; selenides of cadmium and lead; and telluride of cadmium. Illustrative examples of the other compound semiconductor include phosphides of metals such as zinc, gallium, indium, and cadmium; and a gallium arsenide, a copper-indium-selenide, and a copper-indium-sulfide.

Illustrative examples of the compound having the perovskite structure include strontium titanate, calcium titanate, sodium titanate, barium titanate, and potassium niobate.

Among these, oxide semiconductors are preferable, in which more preferable are titanium oxide, zinc oxide, tin oxide, and niobium oxide. When the electron transportable material in the electron transport portion is titanium dioxide, the conduction band is high, so that a high open circuit voltage can be obtained. In addition, the refractive index is so high that due to the light confinement effect a high short circuit current can be obtained. Furthermore, the enhancements in the dielectric constant and the mobility bring about the advantage that a high fill factor can be obtained.

These may be used singly, or in combination of two or more of them. The crystal type of the semiconductor material is not particularly restricted; so, it can be selected as appropriate in accordance with the purpose. This may be any of single crystal, polycrystal, and amorphous.

As for the number-average particle diameter of the primary particles of the semiconductor material, there is no particular restriction; so, this can be selected as appropriate in accordance with the purpose. Nevertheless, the diameter is preferably 1 nm or more and 100 nm or less, while more preferably 5 nm or more and 50 nm or less. In addition, the semiconductor material having the particle diameter larger than the number-average particle diameter may be mixed or stacked. Because the scattering effect of the incident light due to this, the conversion efficiency is prone to be enhanced. In this case, the number-average particle diameter is preferably 50 nm or more and 500 nm or less.

As for the average thickness of the electron transport portion, there is no particular restriction; so, this can be selected as appropriate in accordance with the purpose. Nevertheless, the thickness is preferably 50 nm or more and 100 um or less, and more preferably 100 nm or more and 50 um or less, while still more preferably 120 nm or more and 10 um or less. When the average thickness of the electron transport portion is within the preferable range, the amount of the photosensitizing compound per a unit projected area is sufficiently ensured so as to retain a high light capture rate, and the diffusion distance of the injected electron is not readily increased thereby reducing the losses due to charge recombination.

### Photosensitizing Compound

The photosensitizing compound is adsorbed onto the surface of the semiconductor material that constitutes the electron transport portion in order to further enhance the output and the photoelectric conversion efficiency.

There is no particular restriction in the photosensitizing compound as far as this is the compound that can be photo-excited by the light irradiating the photoelectric conversion device; so, this can be selected as appropriate in accordance with the purpose. Illustrative examples thereof include a metal complex compound, a coumarin compound, a polyene compound, an indoline compound, and a thiophene compound, which are known as photosensitizing compounds.

As for the photosensitizing compound, at least one compound selected from the compounds represented by the following general formula (15) and the following general formula (16) is preferably used.

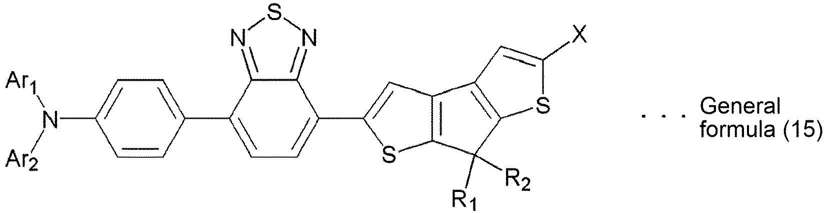

In the general formula (15), Ar₁ and Ar₂ each represent an aryl group which may have a substituent. R₁ and R₂ each represent a linear or a branched alkyl group having the carbon number of 4 to 10. X represents any one of the substituents represented by the following structural formulae.

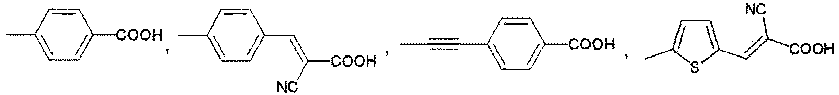

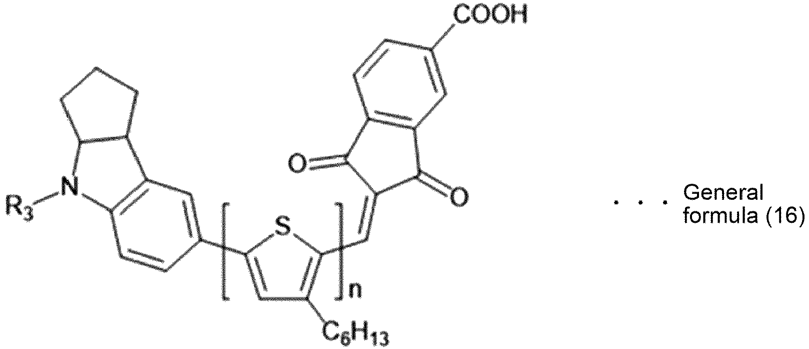

In the general formula (16), n represents an integer of 0 or 1. R₃ represents an aryl group which may have a substituent, or any one of the substituents represented by the following structural formulae.

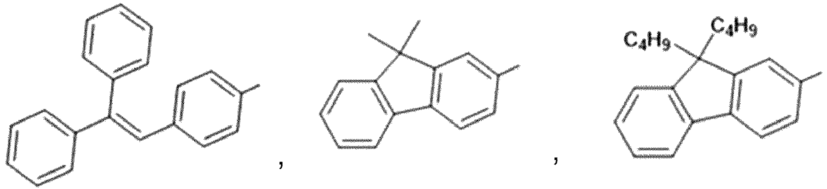

Among the photosensitizing compounds represented by the general formula (15), compounds represented by the following general formula (17) are still more preferably used because a high output can be obtained even with a low luminance light.

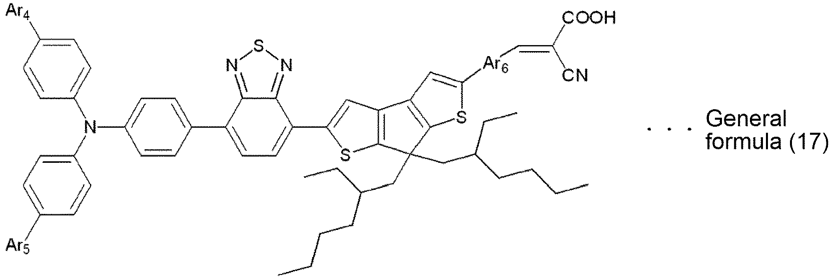

In the general formula (17), Ar₄ and Ar₅ each represent a phenyl group which may have a substituent or a naphthyl group which may have a substituent. Ar₆ represents a phenyl group which may have a substituent or a thiophene group which may have a substituent.

### Hole transport Portion

There is no particular restriction in the hole transport portion; so, a publicly known material can be used as far as it has the function of transporting a hole. Illustrative examples thereof include an electrolyte solution having a redox pair dissolved in an organic solvent, a gel electrolyte in which a polymer is impregnated with a liquid having a redox pair dissolved in an organic solvent, a molten salt containing a redox pair, a solid electrolyte, an inorganic hole transport material, and an organic hole transport material. Among these, although an electrolyte solution and a gel electrolyte can be used, a solid electrolyte is preferable, while an organic hole transport material is more preferable.

Illustrative examples of the organic hole transport material include an oxadiazole compound, a triphenylmethane compound, a pyrazoline compound, a hydrazone compound, an oxadiazole compound, a tetraaryl benzidine compound, a stilbene compound, and a spiro-type compound. Among these, a spiro-type compound is more preferable.

As for the spiro-type compounds, for example, compounds represented by the following general formula (18) are preferable.

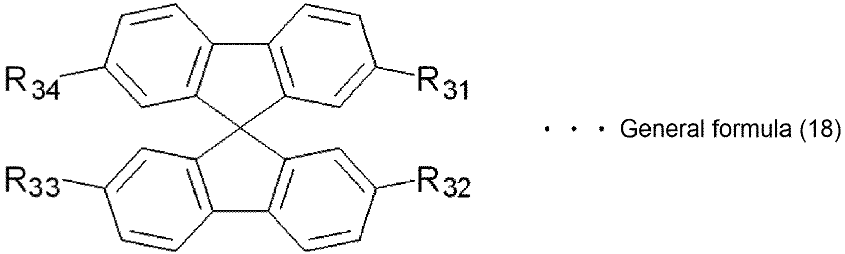

In the general formula (18), R₃₁ to R₃₄ each independently represent substituted amino groups such as a dimethylamino group, a diphenylamino group, and a naphthyl-4-tolylamino group.

In addition, it is preferable that the hole transport layer further contain a lithium salt represented by the following general formula (19).

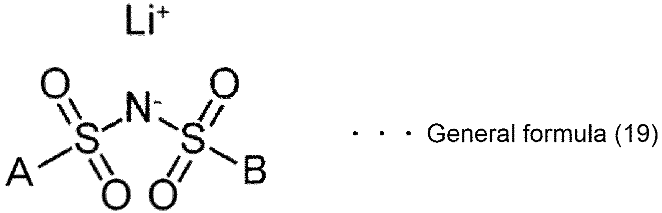

In the general formula (3), A and B each represent any of the substituents F, CF₃, C₂F₅, C₃F₇, and C₄F₉, in which the substituents A and B are different.

Illustrative examples of the lithium salt include lithium (fluorosulfonyl)(trifluoromethanesulfonyl)imide (Li-FTFSI), lithium
(fluorosulfonyl)(pentafluoroethanesulfonyl)imide (Li-FPFSI), lithium (fluorosulfonyl)(nonafluorobutanesulfonyl)imide (Li-FNFSI), lithium
(nonafluorobutanesulfonyl) (trifluoromethanesulfonyl)imide (Li-NFTFSI), and lithium
(pentafluoroethanesulfonyl)(trifluoromethanesulfonyl)imide (Li-PFTFSI). Among these, lithium
(fluorosulfonyl)(trifluoromethylsulfonyl)imide (Li-FTFSI) is especially preferable.

### Photoelectric Conversion Device Relating to Perovskite Solar Cell

As an example other than the photoelectric conversion device relating to the organic thin film solar cell described above, the photoelectric conversion device relating to a perovskite solar cell will be described.

The photoelectric conversion device has at least a first electrode, a photoelectric conversion layer, and a second electrode in sequence. In the case where other layer or the like is inserted between the electrode and the layer, the example thereof may be a photoelectric conversion device having a first electrode, an electron transport layer, a photoelectric conversion layer, a hole transport layer, and a second electrode in sequence.

In addition, the photoelectric conversion device may have a surface protection portion. The surface protection portion is arranged adjacent to the surface of one electrode that is selected from the first electrode and the second electrode and that is not facing the photoelectric conversion layer.

In addition, the photoelectric conversion device has a sealing member. The sealing member is preferably adjacent to the surface protection portion and encapsulates the surface protection portion, one electrode, and the photoelectric conversion layer.

In addition, the photoelectric conversion device has a base (device base) and the like, as needed. The base (device base) is preferably arranged adjacent to the other electrode on the side not facing the photoelectric conversion layer of the other electrode.

In other words, as one example, the photoelectric conversion device has a configuration in which the base (device base), the first electrode, the electron transport layer, the photoelectric conversion layer, the hole transport layer, the second electrode, the surface protection portion, and the sealing member are sequentially stacked. In the following, each component will be described. However, the description about the base (device base), the first electrode, the second electrode, the surface protection portion, and the sealing member will be omitted because in these the same components as those in the photoelectric conversion device for the organic thin film solar cell described above can be used.

### Electron Transport Layer

The electron transport layer transports an electron generated in the photoelectric conversion layer.

The electron transport layer contains an electron transportable material. There is no particular restriction in the electron transportable material; so, this can be selected as appropriate in accordance with the purpose, while a semiconductor material is preferable. There is no particular restriction in the semiconductor material; so, any publicly known materials may be used, such as a single semiconductor and a compound having a compound semiconductor.

Examples of the single semiconductor include silicon and germanium.

Examples of the semiconductor include a metal chalcogenide. Illustrative examples of the metal chalcogenide include a metal oxide (oxide semiconductor), a metal sulfide, a metal selenide, and a metal telluride. Illustrative examples of the metal oxide (oxide semiconductor) include oxides of titanium, tin, zinc, iron, tungsten, zirconium, hafnium, strontium, indium, cerium, yttrium, lanthanum, vanadium, niobium, and tantalum. Illustrative examples of the metal sulfides include sulfides of cadmium, zinc, lead, silver, antimony, and bismuth. Illustrative examples of the metal selenides include selenides of cadmium and lead. Illustrative examples of the metal telluride include cadmium telluride. Illustrative examples of the other compound semiconductor include phosphides of metals such as zinc, gallium, indium, and cadmium; and a gallium arsenide, a copper-indium-selenide, and a copper-indium-sulfide.

Among these, metal oxides (oxide semiconductors) are preferable, in which more preferable are those containing at least one of titanium oxide, zinc oxide, tin oxide, and niobium oxide, while tin oxide is especially preferable. These may be used singly, or in combination of two or more of them. The crystal type of the semiconductor material is not particularly restricted; so, it can be selected as appropriate in accordance with the purpose. This may be any of single crystal, polycrystal, and amorphous.

### Photoelectric Conversion Layer

The photoelectric conversion layer is the layer that carries out the photoelectric conversion and has a perovskite layer containing a perovskite compound.

The perovskite compound is the composite material of an organic compound and an inorganic compound, which can be represented by the following general formula (20).

X_{α}Y_{β}M*_{γ}* · · · General formula (20)

In the general formula (20), the ratio of α:β:γ is 3:1:1, where β and γ are integers greater than 1. For example, X can be a halogen ion, Y can be an ion of an organic compound having an amino group, and M can be a metal ion.

X in the above general formula (20) is not particularly restricted and can be selected in accordance with to the purpose; for example, halogen ions such as chlorine, bromine, and iodine may be used. These may be used singly, or in combination of two or more of them.

Y in the above general formula (20) can be an organic cation, such as an ion of an alkylamine compound including methylamine, ethylamine, n-butylamine, and formamidine, or an inorganic alkali metal cation, such as an ion of cesium, potassium, and rubidium. They may be used singly or in combination of two or more of them, and may be used in combination of an inorganic alkali metal cation with an organic cation.

M in the above general formula (20) is not particularly restricted and can be selected in accordance with the purpose. For example, an ion of a metal such as lead, indium, antimony, tin, copper, and bismuth may be used. These may be used singly, or in combination of two or more of them.

It is preferable that the perovskite layer have a layered perovskite structure in which a layer of a metal halide and a layer having organic cationic molecules lined are alternately stacked.

### Hole Transport Layer

The hole transport layer transports a hole that is generated in the photoelectric conversion layer.

The hole transport layer contains a hole transportable material. There is no particular restriction in the hole transportable material; so, this can be selected as appropriate in accordance with the purpose, while it is preferable to include, for example, a compound having a repeating structure represented by the following general formula (21) and a compound represented by the following general formula (22).

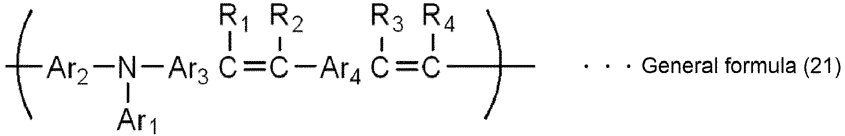

Ar₁ in the general formula (21) represents an aryl group. Illustrative examples of the aryl group include a phenyl group, a 1-naphthyl group, and a 9-anthracenyl group. The aryl group may have a substituent. Illustrative examples of the substituent include an alkyl group, an alkoxy group, and an aryl group. Ar₂, Ar₃, and Ar₄ each independently represent an arylene group, and a divalent heterocyclic group. Illustrative examples of the arylene group include 1,4-phenylene, 1,1'-biphenylene, and 9,9'-din-hexylfluorene. The divalent heterocyclic group may be, for example, 2,5-thiophene. R₁ to R₄ each independently represent a hydrogen atom, an alkyl group, and an aryl group. Illustrative examples of the alkyl group include a methyl group and an ethyl group. Illustrative examples of the aryl group include a phenyl group and a 2-naphthyl group. The alkyl group and the aryl group may have a substituent.

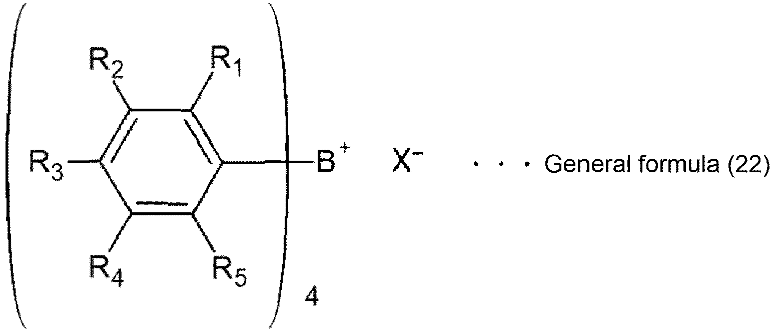

In the general formula (22), R₁ to R₅ each represent a hydrogen atom, a halogen atom, an alkyl group, an alkoxy group, or an aryl group, which may be the same or different. X represents a cation. R₁ and R₂, or R₂ and R₃ may together form a ring structure.

Illustrative examples of the halogen atom include a chlorine atom, a bromine atom, and an iodine atom.

Alkyl groups include, for example, alkyl groups having the carbon number of 1 to 6. The alkyl group may be substituted with a halogen atom.

The alkoxy group may be, for example, an alkoxy group having the carbon number of 1 to 6.

The aryl group may be, for example, a phenyl group.

There is no particular restriction in the cation; so, this can be selected as appropriate in accordance with the purpose. Illustrative examples thereof include an alkali metal cation, a phosphonium cation, an iodonium cation, a nitrogen-containing cation, and a sulfonium cation. The nitrogen-containing cation here mean the ion having a positive charge on a nitrogen atom, such as an ammonium cation, a pyridinium cation, and an imidazolium cation.

There is no particular restriction in the hole transportable material other than the compound having a repeating structure represented by the general formula (21) and the compound represented by the general formula (22) as far as the material has the hole transportable property; so, this can be selected as appropriate in accordance with the purpose. Here, an organic compound is preferable, including a polymer material and a low molecular-weight material as described below.

There is no particular restriction in the polymer material used in the hole transport layer; so, this can be selected as appropriate in accordance with the purpose. Illustrative examples thereof include a polythiophene compound, a polyphenylenevinylene compound, a polyfluorene compound, a polyphenylene compound, and a polythiadiazole compound.

Illustrative examples of the polythiophene compound include poly(3-n-hexylthiophene), poly(3-n-octylthiophene), poly(9,9'-dioctyl-fluorene-co-bithiophene), poly(3,3'''-didodecyl-quaterthiophene), poly(3,6-dioctylthieno[3,2-b]thiophene), poly(2,5-bis(3-decylthiophen-2-yl)thieno[3,2-b]thiophene), poly(3,4-didecylthiophene-co-thieno[3,2-b]thiophene), poly(3,6-dioctylthieno[3,2-b]thiophene-co-thieno[3,2-b]thiophene), poly(3,6-dioctylthieno[3,2-b]thiophene-co-thiophene), and poly(3,6-dioctylthieno[3,2-b]thiophene-co-bithiophene).

Illustrative examples of the polyphenylene vinylene compound include poly[2-methoxy-5-(2-ethylhexyloxy)-1,4 phenylenevinylene], poly[2-methoxy-5-(3,7-dimethyloctyloxy)-1,4-phenylenevinylene], and poly[(2-methoxy-5-(2-ethylphenylhexyloxy)-1,4-phenylenevinylene)-co-(4,4'-biphenylene-vinylene)].

Illustrative examples of the polyfluorene compound include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], and poly[(9,9-dioctyl-2,7-diyl)-co-(1,4-(2,5-dihexyloxy)benzene)].

Illustrative examples of the polyphenylene compound include poly[2,5-dioctyloxy-1,4-phenylene] and poly[2,5-di(2-ethylhexyloxy)-1,4-phenylene].

Illustrative examples of the polythiadiazole compound include poly[(9,9-dioctylfluorenyl-2,7-diyl)-alt-co-(1,4-benzo(2,1',3)thiadiazole)] and poly(3,4-didecylthiophene-co-(1,4-benzo(2,1',3)thiadiazole).

There is no particular restriction in the low-molecular weight material used in the hole transport layer; so, this can be selected as appropriate in accordance with the purpose. Illustrative examples thereof include an oxadiazole compound, a triphenylmethane compound, a pyrazoline compound, a hydrazone compound, a tetraarylbenzidine compound, a stilbene compound, a spirobifluorene compound, and a thiophene oligomer.

### Electronic Device

The electronic device has at least the photoelectric conversion device described above (this may also be a photoelectric conversion module having a plurality of the photoelectric conversion devices) and a device that is electrically connected to the said photoelectric conversion device. The device that is electrically connected to the photoelectric conversion device is the device that can act by an electric power or the like generated by photoelectric conversion by the photoelectric conversion device. The electronic device may have a plurality of embodiments depending on the use thereof, including a first embodiment and a second embodiment described below.

The first embodiment is the electronic device having the photoelectric conversion device, the device that is electrically connected to the said photoelectric conversion device, and other devices as needed.

The second embodiment is the electronic device having the photoelectric conversion device, a storage battery that is electrically connected to the said photoelectric conversion device, a device that is electrically connected to the said photoelectric conversion device and to the storage battery, and other devices as needed.

### Power Supply Module

The power supply module has at least the photoelectric conversion device, a power supply IC (Integrated Circuit) that is electrically connected to the said photoelectric conversion device, and other devices as needed.

### Usage

The photoelectric conversion device can function as a stand-alone power source, in which the power generated by the photoelectric conversion can be used to cause the device to be operated. Because the photoelectric conversion device can generate an electricity when irradiated with light, there is no need to connect the electronic device to an external power source or to exchange a battery. This enables the electronic device to be operated in a place where there is no power supply device, to be carried around by wearing it, and to be operated without exchanging a battery in a place where it is difficult to replace it. In addition, when a dry battery is used in an electronic device, the electronic device increases the weight and size thereof, thereby making it difficult to install on a wall or a ceiling or to carry around. However, the photoelectric conversion device is light and thin, so that not only this has high freedom in selection of the installation place thereof but also it is advantageous when it is worn or is carried around.

Accordingly, because the photoelectric conversion device can be used as a stand-alone power source, the electronic device equipped with the photoelectric conversion device can be used for various applications. Illustrative examples of the application of the electronic device mounted with the photoelectric conversion device include: display devices such as an electronic desktop calculator, a wristwatch, a cellular phone, an electronic organizer, and an electronic paper; personal computer accessories such as a personal computer mouse and a personal computer keyboard; various sensing devices such as a temperature/humidity sensor and a human sensor; transmitters such as a beacon and a global positioning system (GPS), an auxiliary light, and a remote control.

The photoelectric conversion device of the present disclosure can generate an electricity even with a low illuminance. The low illuminance is, for example, an illuminance by lighting or the like in an indoor environment. Specifically, the illuminance in this is 20 lux or more and 1,000 lux or less, which is extremely low as compared to the direct sun light (approximately 100,000 lux). In other words, this can generate a power indoors, even in a dimly lit shadow, thereby making this applicable to a wide range of applications. This is safe as well, because there is no leakage like a dry battery and this cannot be accidentally swallowed like a button battery. Moreover, this can be used as an auxiliary power source to extend the continuous use time of a rechargeable or a dry-cell powered electric appliance. Accordingly, by combining the photoelectric conversion device with a device that acts by an electric power generated by photoelectric conversion by the photoelectric conversion device, an electronic device that is lightweight, easy to use, flexible in an installation place, not requiring replacement, highly safe, and effective in reducing an environmental impact can be obtained. Therefore, the electronic device equipped with the photoelectric conversion device can be used for a variety of applications.

FIG. 7 is a schematic diagram of one example illustrating the basic configuration of the electronic device that combines the photoelectric conversion device with a device circuit that is operated by the power generated by photoelectric conversion by the photoelectric conversion device. When the photoelectric conversion device is irradiated with light, this generates an electricity, from which a power can be taken out thereby enabling to operate the device circuit by this power.

However, because the output of the photoelectric conversion device varies with an ambient illuminance, the electronic device illustrated in FIG. 7 does not always act stably. Therefore, in this case, in order to supply a stable voltage to the device circuit side, it is preferable to incorporate a power supply IC between the photoelectric conversion device and the device circuit, as illustrated in the schematic diagram of one example of the basic configuration of the electronic device in FIG. 8.

The photoelectric conversion device can generate an electricity when exposed to light of a sufficient illuminance; but when the illuminance is not enough to generate an electricity, the intended power cannot be obtained, which is also a drawback of the photoelectric conversion device. In this case, as illustrated in the schematic diagram of one example of the basic configuration of the electronic device in FIG. 9, by installing an electric storage device such as a capacitor between the power supply IC and the device circuit, a surplus power from the photoelectric conversion device can be charged into the electric storage device. Accordingly, even when the illuminance is too low or the photoelectric conversion device is not illuminated, the power stored in the electric storage device can be supplied to the device circuit, so that the device circuit can act stably.

In this way, in the electronic device that combines the photoelectric conversion device with the device circuit, by combining the power supply IC with the electric storage device, the device can be operated even in an environment without a power supply, and can be driven stably without the need of battery replacement, so that the electronic device equipped with the photoelectric conversion device can be used for various applications.

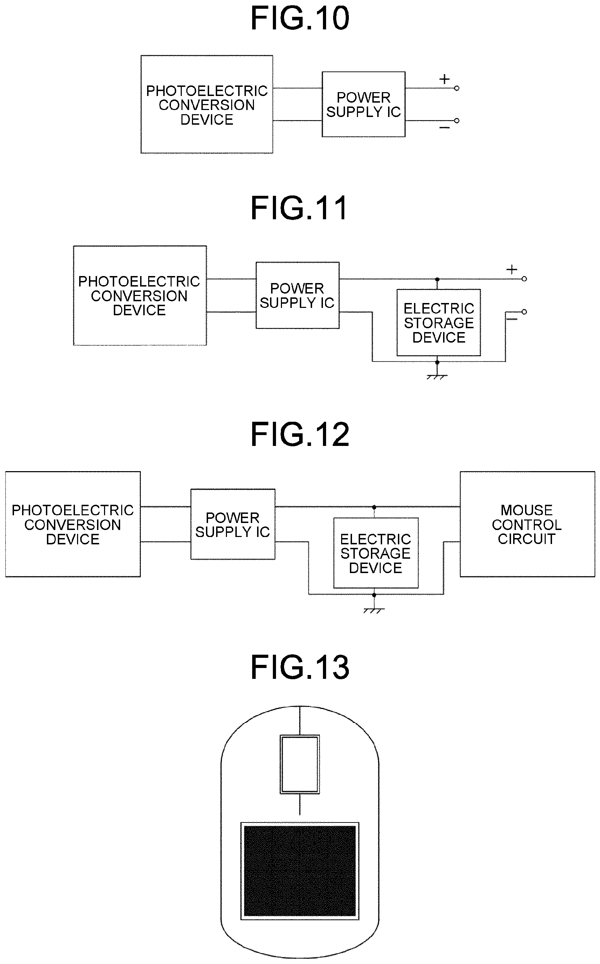

In addition, the photoelectric conversion device can be used as a power supply module as well. For example, as illustrated in the schematic diagram in FIG. 10 that illustrates one example of the basic configuration of the power supply module, when the photoelectric conversion device is connected to the power supply IC, a direct current power supply module can be constructed that can supply the power generated by photoelectric conversion by the photoelectric conversion device at a constant voltage level with the power supply IC.

Furthermore, as illustrated in the schematic diagram of one example of the basic configuration of the power supply module in FIG. 11, by adding the electric storage device to the power supply IC, the power generated by the photoelectric conversion device can be charged into the electric storage device. Accordingly, the power supply module that can supply the power, even when the illuminance is very low or when no light is available to the photoelectric conversion device, can be constructed.

The power supply modules illustrated in FIGS. 10 and 11 can be used as the power supply module without replacing batteries as with case of the conventional primary battery. Accordingly, the power supply module having the photoelectric conversion device can be used for various applications.

Hereinafter, specific applications of the electronic device having the photoelectric conversion device and the device operable by an electric power will be described.

### Application for Personal Computer Mouse

FIG. 12 is a schematic diagram illustrating one example of the basic configuration of a personal computer mouse (hereinafter this is also referred to as "mouse") as one example of the electronic device. As illustrated in FIG. 12, the mouse has the photoelectric conversion device, a power supply IC, an electric storage device, and a mouse control circuit. The power for the mouse control circuit is supplied from the connected photoelectric conversion device or by the electric storage device. This allows the electric storage device to be charged when the mouse is not in use thereby causing the mouse to be operated with this power; thus, the mouse that does not require wiring or battery replacement can be obtained. In addition, because a battery is not necessary, the weight of the device can be reduced so that this is suitably used for the mouse application.

FIG. 13 is a schematic appearance of one example of a personal computer mouse illustrated in FIG. 12. As illustrated in FIG. 13, the photoelectric conversion device, the power supply IC, the electric storage device, and the mouse control circuit are mounted inside the mouse, in which the top of the photoelectric conversion device is covered by a transparent housing to allow light to reach the photoelectric conversion device. The entire mouse housing can also be molded with a transparent resin. The placement of the photoelectric conversion device is not limited to this; for example, this can be placed in a position where light hits the photoelectric conversion device even when the mouse is covered by a hand.

### Personal Computer Keyboard Application

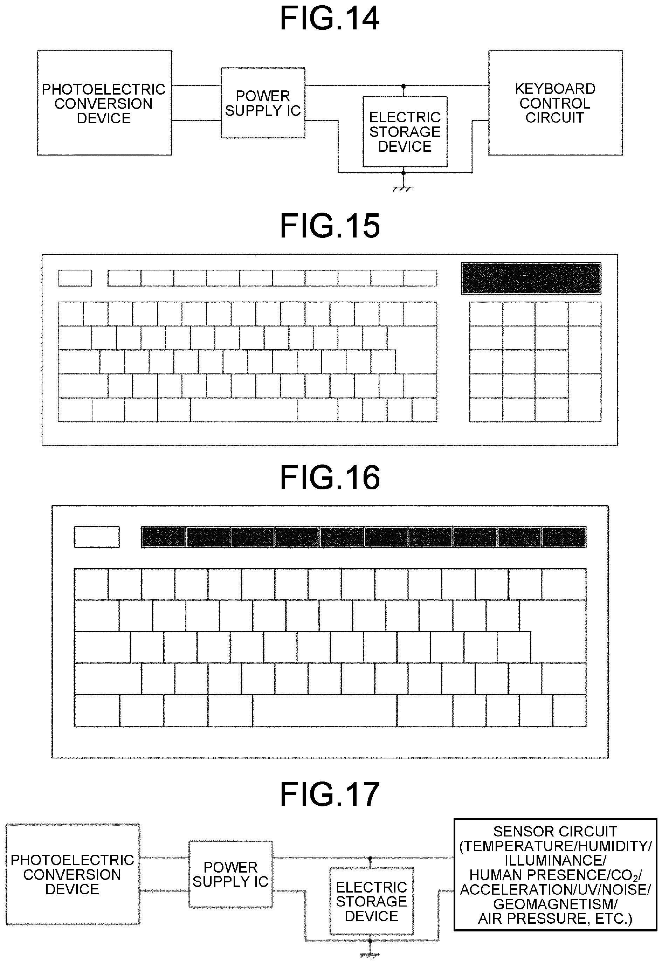

FIG. 14 is a schematic diagram illustrating one example of the basic configuration of a personal computer keyboard (hereinafter this is also referred to as "keyboard") as one example of the electronic device. As illustrate in FIG. 14, the keyboard has the photoelectric conversion device, the power supply IC, the electric storage device, and a keyboard control circuit. The power for the keyboard control circuit is supplied by the connected photoelectric conversion device or by the electric storage device. This allows the keyboard to be charged to the electric storage device when the keyboard is not in use, and the keyboard to be operated with this power, so that the keyboard that does not require wiring or battery replacement can be obtained. In addition, because a battery is not necessary, the weight of the device can be reduced so that this is suitably used for the keyboard application.

FIG. 15 is a schematic appearance of the personal computer keyboard illustrated in FIG. 14. As illustrated in FIG. 15, the photoelectric conversion device, the power supply IC, the electric storage device, and a keyboard control circuit are mounted inside the keyboard, in which the top of the photoelectric conversion device is covered by a transparent housing to allow light to reach the photoelectric conversion device. The entire keyboard housing can also be molded with a transparent resin. The placement of the photoelectric conversion device is not limited to this. For example, when the keyboard has a small space for the photoelectric conversion device to be incorporated, a small photoelectric conversion device can be embedded in a part of the keys, as illustrated in the schematic appearance of another example of the personal computer keyboard in FIG. 16.

### Sensor Application

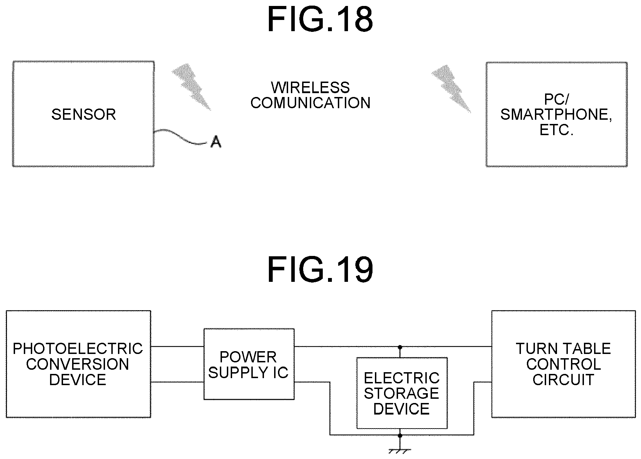

FIG. 17 is a schematic diagram illustrating one example of the basic configuration of a sensor as one example of the electronic device. As illustrated in FIG. 17, the sensor has the photoelectric conversion device, the power supply IC, the electric storage device, and a sensor circuit. The power for the sensor circuit is supplied by the connected photoelectric conversion device or by the electric storage device. This allows the sensor to be configured without the need to connect to an external power supply or to replace the battery. Sensing targets of the sensor can include temperature, humidity, illuminance, human presence, CO₂, acceleration, UV, noise, geomagnetism, and air pressure. It is preferable that the sensor periodically sense the measurement target and transmit the acquired data to a personal computer (PC) or a smartphone via a wireless communication, as illustrated in A in FIG. 18.

With the advent of the Internet of Things (IoT) society, sensors are expected to proliferate rapidly. On the other hand, replacing the battery for each of these myriad sensors would be cumbersome, and thus would be impractical. The workability of sensor is also deteriorated when this is placed in the location where it is difficult to replace the battery, such as a ceiling and a wall. Therefore, the sensor that can be empowered by the photoelectric conversion device is of a great advantage. The photoelectric conversion device according to the present disclosure also has the advantages that the output is high even at a low illuminance and has low dependency on the light incident angle, which bring about a high degree of freedom in selection of the installation location thereof.

### Turntable Application

FIG. 19 is a schematic diagram illustrating one example of the basic configuration of a turntable as one example of the electronic device. As illustrated in FIG. 19, the turntable has the photoelectric conversion device, the power supply IC, the electric storage device, and a turntable control circuit. The power for the turntable control circuit is supplied by the connected photoelectric conversion device or by the electric storage device. This allows the turntable to be configured without the need to connect to an external power supply or to replace the battery. The turntable is used, for example, in a showcase that display merchandises, in which the wiring for the power supply is unattractive. In addition, when the battery is replaced, the displayed items need to be removed with a cumbersome work. Therefore, the turntable that can be empowered by the photoelectric conversion device is of a great advantage.

### Examples

Hereinafter, Examples of the present invention will be described, but the present invention is not limited to these Examples at all.

### Example 1

### Preparation of Photoelectric Conversion Device

### (Preparation of Organic Thin Film Solar Cell)

### Base Having First Electrode

First, a polyethylene terephthalate (PET) base (50 mm x 50 mm) having a gas barrier layer patterned with an indium-doped tin oxide (ITO) was purchased from Geomatech Co., Ltd. As illustrated in FIG. 6B, the first dividing portion was formed in the first electrode.

### Formation of First Electron Transport Layer

Next, a solution of zinc oxide nanoparticle (average particle diameter of 12 nm, manufactured by Aldrich) was spin-coated onto the ITO gas barrier PET film (15 Ω/sq) at 3,000 rpm and dried at 100°C for 10 minutes to form the first electron transport layer.

### Formation of Second Electron Transport Layer

### (Intermediate Layer)

Next, dimethylaminobenzoic acid (manufactured by Tokyo Chemical Industry Co., Ltd.) was dissolved in ethanol to prepare a 1 mg/ml solution, which was then spin-coated onto the first electron transport layer at 3,000 rpm to form the second electron transport layer having the average thickness of less than 10 nm.

### Formation of Photoelectric Conversion Layer

Next, 16 mg of the example compound 1 described below (number-average molecular weight (Mn) of 1,463, the highest occupied molecular orbital (HOMO) level of 5.27 eV), 1 mg of the example compound 2 described below (number-average molecular weight (Mn) of 15,000, the highest occupied molecular orbital (HOMO) level of 5.33 eV), and 10 mg of the example compound 3 described below were dissolved in 1 mL of chloroform to obtain the photoelectric conversion layer coating liquid A. 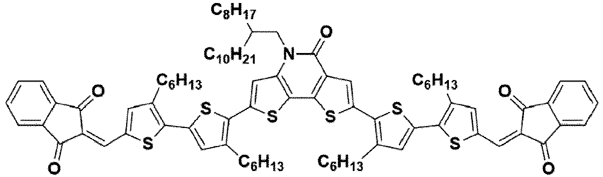 Example Compound 1 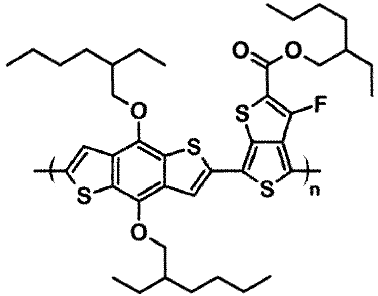 Example Compound 2 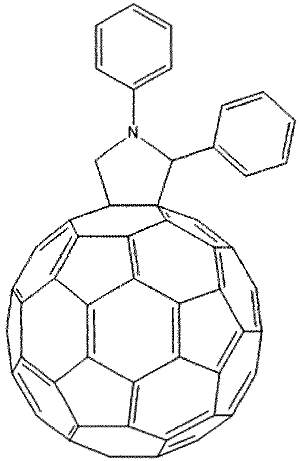 Example Compound 3

Next, the photoelectric conversion layer coating liquid A was spin-coated onto the intermediate layer at 600 rpm to form the photoelectric conversion layer having the average thickness of 220 nm.

### Formation of Penetrating Portion

Next, the penetrating portion was formed as the preliminary step to form the connecting portion that connects between the photoelectric conversion devices in series. The penetrating portion was formed (deleted) using a laser deletion. The shape of the penetrating portion was rectangular in the plane view of the photoelectric conversion device viewed from the second electrode side.

### Formation of Hole Transport Layer, Second Electrode, and Connecting Portion

Next, a hole transport layer material composed of molybdenum oxide (manufactured by Japan Pure Chemical Co., Ltd.) having the average thickness of 50 nm and a second electrode material composed of silver having the average thickness of 100 nm were sequentially deposited by vacuum vapor deposition onto the photoelectric conversion layer and the penetrating portion to form the hole transport layer, the second electrode, and the connecting portion. As illustrated in FIG. 6I, the second dividing portion was formed on the second electrode.

### Formation of Surface Protection Portion

Next, a material for the surface protection portion composed of a fluorine-based silane compound (DURASURF DS-5935F130; the compound that satisfies the general formula (A), manufactured by Harves Co., Ltd.) was spin-coated onto the second electrode at 1,000 rpm.

### Formation of Sealing Zone

Next, the outer periphery (3 mm width) in the stacked layer from the formed electron transport layer to the surface protection layer was removed using a laser processing machine (manufactured by TOWA Laserfront Corp.) to expose the first electrode thereby forming the sealing zone on the first electrode.

### Formation of Sealing Member

Next, the sealing member, which was formed by sequentially laminating a polyolefin resin adhesive member (pressure-sensitive adhesive resin, manufactured by MORESCO Corp.) and an Al/PET laminated gas barrier member (manufactured by Toyo Aluminium K.K.), was disposed in such a way as to encapsulate the layers from the electron transport layer to the surface protection layer and to be in contact with the sealing zone on the first electrode; then, these were bonded using a vacuum laminator (manufactured by Joyo Engineering Co., Ltd.) with an applied pressure of 0.2 MPa.

### Formation of End Shape of Sealing Member

Next, by using a laser marker (manufactured by Seishin Trading Co., Ltd.), the end of the sealing member in the surface direction was processed such that the length of the insulating layer in the surface direction was equal to or longer than the length of the metal layer in the surface direction, and the length of the metal layer in the surface direction was longer than the length of the base in the surface direction to obtain the photoelectric conversion device.

### Calculation of Short-circuit Occurrence Rate after Surface Load Test

First, the current-voltage characteristic of the produced photoelectric conversion device was measured under irradiation of a white LED (color temperature of 5,000 K and illuminance of 200 lx.). The measurement was done using a white LED irradiation with a bulb-type LED lamp (LDA11N-G/40W, manufacture by Toshiba Lighting and Technology Corp.) and an evaluation instrument (source meter) of KETSIGHT B2902A. The output of the LED light source was measured using a spectrometer C-7000, manufactured by Sekonic Co.

Next, a surface load test was conducted as follows. Namely, the photoelectric conversion device having the photoelectric conversion efficiency thereof measured was placed between two glass plates having the thickness of 0.7 mm and a smooth surface; then, after this was placed on a horizontal table, a weight was placed on it to apply a stress of approximately 1,422 N/m² for about 1 minute in accordance with JIS 8938-1995.

Next, the photoelectric conversion device after the surface load test was taken out and the current-voltage characteristic was measured in the same way as the surface load test. When the open circuit voltage after the surface load test was less than 10% of the open circuit voltage before the surface load test, it was judged that a short circuit had occurred; so, this was counted as the number of the short circuit occurred. However, as a result of the optical microscope observation of the device that occurred the short circuit, when a factor other than conduction at the end of the sealing member, such as a film defect in the photoelectric conversion zone, was considered as the cause of the short circuit, this was excluded from the count. This measurement was performed to 50 photoelectric conversion devices. As a result, the short-circuit occurrence rate, which is the ratio of the number of short circuits to the total number of measurements, was calculated to be 0%.

### Measurement of End Shape (Δ1 and Δ2) of Sealing Member

Another photoelectric conversion device was prepared with the same preparation condition as the photoelectric conversion device used in the measurement of the short circuit occurrence rate after the surface load test described above, and sections of the photoelectric conversion device in the surface including the stacking direction at three locations were exposed by using Ion Milling (manufactured by Hitachi High-Tech Corp.); then, the end of the sealing member in the surface direction was observed by a scanning electron microscopy (SEM, manufactured by Carl Zeiss AG). Next, in the observation image, the position where about 500 um apart from the end of the most protruding part of the sealing member among the adhesive member (insulating layer), the metal layer (Al), and the base (PET) toward the photoelectric conversion zone in the surface direction was determined; then, a reference line L₀, which passed through this position in parallel to the stacking direction, was set. Next, the maximum length L₂₁ between the reference line L₀ and the end of the adhesive member (insulating layer) in the surface direction, the maximum length L₂₃ between the reference line L₀ and the end of the metal layer in the surface direction, and the maximum length L₂₄ between the reference line L₀ and the end of the base (PET) in the surface direction each were measured; then, from the lengths L₂₁, L₂₃, and L₂₄, Δ1 (L₂₁-L₂₃) and Δ2 (L₂₃-L₂₄) were determined. The average values of Δ1 and Δ2 at the three locations for each were calculated to obtain Δ1 of 5.0 um and Δ2 of 10.0 µm. These values were less than 150 nm from the target values at the time of processing.

### Example 2

### Preparation of Photoelectric Conversion Device

### (Preparation of Organic Thin Film Solar Cell)

In the preparation of the photoelectric conversion device in Example 1, the photoelectric conversion device was prepared in the same way as in Example 1, except that the end shape of the sealing member was processed so as to give Δ1 of 0 um and Δ2 of 10.0 um.

In the same way as Example 1, the calculation of the short circuit occurrence rate after the surface load test and the measurement of the end shape (Δ1 and Δ2) of the sealing member were carried out. The results are listed in Table 1.

### Example 3

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of 0 um and Δ2 of 2.0 um. In the same way as Example 1, the calculation of the short circuit occurrence rate after the surface load test and the measurement of the end shape (Δ1 and Δ2) of the sealing member were carried out. The results are listed in Table 1.

### Example 4

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of 0 um and Δ2 of 1.0 um.

In the same way as Example 1, the calculation of the short circuit occurrence rate after the surface load test and the measurement of the end shape (Δ1 and Δ2) of the sealing member were carried out. The results are listed in Table 1.

### Example 5

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of 0 um and Δ2 of 0.9 um.

In the same way as Example 1, the calculation of the short circuit occurrence rate after the surface load test and the measurement of the end shape (Δ1 and Δ2) of the sealing member were carried out. The results are listed in Table 1.

### Example 6

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of 0 um and Δ2 of 0.5 um.

In the same way as Example 1, the calculation of the short circuit occurrence rate after the surface load test and the measurement of the end shape (Δ1 and Δ2) of the sealing member were carried out. The results are listed in Table 1.

### Example 7

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of 0 um and Δ2 of 0.1 um.

In the same way as Example 1, the calculation of the short circuit occurrence rate after the surface load test and the measurement of the end shape (Δ1 and Δ2) of the sealing member were carried out. The results are listed in Table 1.

### Example 8

### Preparation of Photoelectric Conversion Device

### (Preparation of Organic Thin Film Solar Cell)

In the preparation of the photoelectric conversion device in Example 7, the photoelectric conversion device was prepared in the same way as in Example 7 except that the photoelectric conversion layer coating liquid A was changed to the photoelectric conversion layer coating liquid B described below.

In the same way as Example 1, the calculation of the short circuit occurrence rate after the surface load test and the measurement of the end shape (Δ1 and Δ2) of the sealing member were carried out. The results are listed in Table 1.

### Photoelectric Conversion Layer coating liquid B

The photoelectric conversion layer coating liquid B was prepared by dissolving 16 mg of the example compound 4 described below (number-average molecular weight (Mn) of 1,554 and the highest occupied molecular orbital (HOMO) level of 5.13 eV), 1 mg of the example compound 5 described below (number-average molecular weight (Mn) of 58,737 and the highest occupied molecular orbital (HOMO) level of 5.33 eV, manufactured by Ossila Ltd.), and 10 mg of PC61BM (E100H, manufactured by Frontier Carbon Corp.) in 1 mL of chloroform. 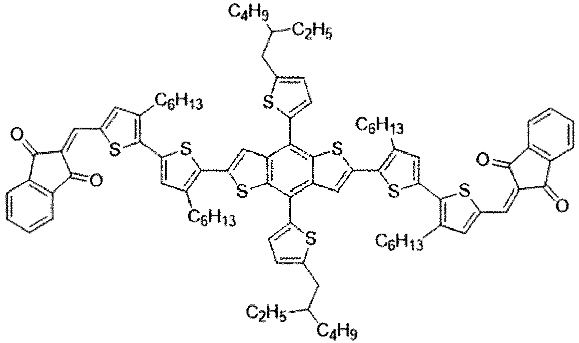 Example Compound 4 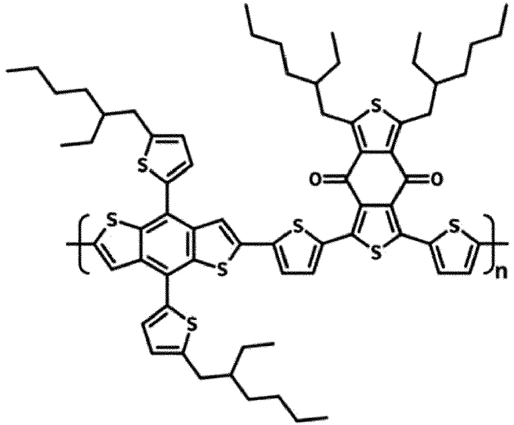 Example Compound 5

### Example 9

### Preparation of Photoelectric Conversion Device

### (Preparation of Organic Thin Film Solar Cell)

In the preparation of the photoelectric conversion device in Example 7, the photoelectric conversion device was prepared in the same way as in Example 7 except that the photoelectric conversion layer coating liquid A was changed to the photoelectric conversion layer coating liquid C described below.

In the same way as Example 1, the calculation of the short circuit occurrence rate after the surface load test and the measurement of the end shape (Δ1 and Δ2) of the sealing member were carried out. The results are listed in Table 1.

### Photoelectric Conversion Layer coating liquid C

The photoelectric conversion layer coating liquid C was prepared by dissolving 16 mg of the example compound 6 described below (number-average molecular weight (Mn) of 1,886 and the highest occupied molecular orbital (HOMO) level of 5.00 eV) and 10 mg of PC61BM (E100H, manufactured by Frontier Carbon Corp.) in 1 mL of chloroform. 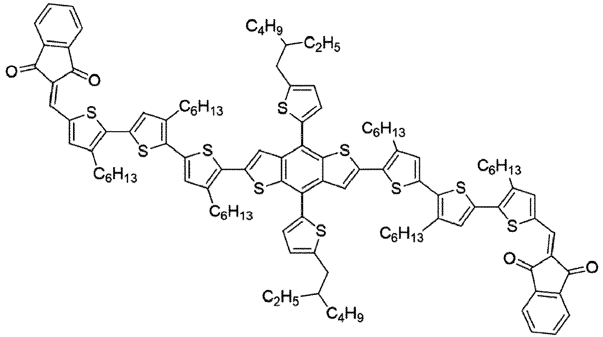 Example Compound 6

### Example 10

### Preparation of Photoelectric Conversion Device

### (Preparation of Organic Thin Film Solar Cell)

In the preparation of the photoelectric conversion device in Example 7, the photoelectric conversion device was prepared in the same way as in Example 7 except that the photoelectric conversion layer coating liquid A was changed to the photoelectric conversion layer coating liquid D described below.

In the same way as Example 1, the calculation of the short circuit occurrence rate after the surface load test and the measurement of the end shape (Δ1 and Δ2) of the sealing member were carried out. The results are listed in Table 1.

### Photoelectric Conversion Layer coating liquid D

The photoelectric conversion layer coating liquid D was prepared by dissolving 16 mg of the example compound 1 described before (number-average molecular weight (Mn) of 1,463 and the highest occupied molecular orbital (HOMO) level of 5.27 eV), 1 mg of the example compound 2 described before (number-average molecular weight (Mn) of 15,000 and the highest occupied molecular orbital (HOMO) level of 5.33 eV), and 10 mg of the example compound 7 described below (ITIC-F, manufactured by Merck Corp.) in 1 mL of chloroform. 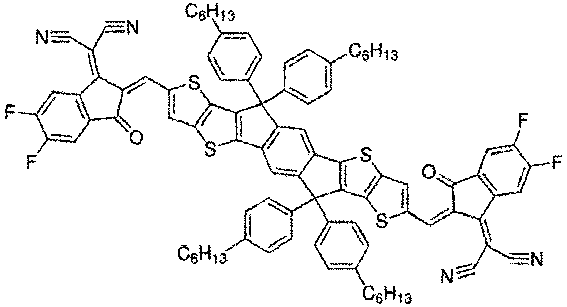 Example Compound 7

### Example 11

### Preparation of Photoelectric Conversion Device

### (Preparation of Organic Thin Film Solar Cell)

In the preparation of the photoelectric conversion device in Example 7, the photoelectric conversion device was prepared in the same way as in Example 7 except that the second electron transport layer (intermediate layer) was not formed.

In the same way as Example 1, the calculation of the short circuit occurrence rate after the surface load test and the measurement of the end shape (Δ1 and Δ2) of the sealing member were carried out. The results are summarized in Table 1.

### Example 12

### Preparation of Photoelectric Conversion Device

### (Preparation of Organic Thin Film Solar Cell)

In the preparation of the photoelectric conversion device in Example 7, the photoelectric conversion device was prepared in the same way as in Example 7 except that the first electron transport layer was not formed.

In the same way as Example 1, the calculation of the short circuit occurrence rate after the surface load test and the measurement of the end shape (Δ1 and Δ2) of the sealing member were carried out. The results are listed in Table 1.

### Example 13

### Preparation of Photoelectric Conversion Device

### (Preparation of Dye-sensitized Solar Cell)

A dense layer consisting of titanium oxide as a holeblocking layer was formed by a reactive sputtering with an oxygen gas onto an ITO-coated glass, which was formed by sputtering an ITO conductive film as the first electrode onto a glass base.

Next, 3 g of titanium oxide (trade name: P90, manufactured by AEROSIL JAPAN Co., Ltd.), 0.2 g of acetylacetone, and 0.3 g of polyoxyethylene octylphenyl ether (manufactured by Wako Pure Chemical Industries, Ltd.) as a surfactant were mixed with 5.5 g of water and 1.0 g of ethanol for 12 hours using a bead mill to obtain a titanium oxide dispersion liquid. To the resulting titanium oxide dispersion liquid, 1.2 g of polyethylene glycol (trade name: polyethylene glycol 20,000, manufactured by Wako Pure Chemical Industries, Ltd.) was added to prepare a paste. The paste thereby prepared was applied onto the hole blocking layer (average thickness of 1.5 pm), dried at 50°C, and fired at 500°C in an air for 30 minutes to form a porous electron transport layer.

Next, the glass base on which the electron transport layer was formed was immersed in an acetonitrile/t-butanol solution (volume ratio 1:1) of the photosensitizing compound represented by the example compound 8 described below (trade name: D358, Mitsubishi Paper Mills Ltd.); then, this was allowed to statically leave in a dark place for 1 hour so that the photosensitizing compound was adsorbed onto the surface of the electron transport layer.

Next, 19.0 mg of the alkali metal salt represented by the example compound 10 described below (Kanto Chemical Co., Ltd.), 37.5 mg of the basic compound represented by the example compound 11 described below, and 12. 5 mg of the oxidizing agent represented by the example compound 12 described below (trade name: FK269, Sigma-Aldrich Japan K.K.) were dissolved in 1 mL of the chlorobenzene solution of 186.5 mg of the hole transport material represented by the example compound 9 described below (manufactured by Merck Ltd.) to prepare the hole transport layer coating liquid. Then, the hole transport layer coating liquid was spin-coated onto the electron transport layer having the photosensitizing compound adsorbed thereto to form the hole transport layer (average thickness of 600 nm).

Next, silver was vacuum vapor-deposited on the hole transport layer to form the second electrode (average thickness of 100 nm).

Next, a material for the surface protection portion composed of a fluorine-based silane compound (DURASURF DS-5935F130; the compound that satisfies the general formula (A), manufactured by Harves Co., Ltd.) was spin-coated onto the second electrode at 1,000 rpm.

Next, in the surface parallel to the light-receiving surface, the hole transport layer on the outer periphery, in which the electron transport layer was not formed, was removed using a laser processing machine (manufactured by TOWA Laserfront Corp.) to expose the first electrode, thereby forming the sealing zone on the first electrode.

Next, the sealing member, which was formed by sequentially laminating a polyolefin resin adhesive member (pressure-sensitive adhesive resin, manufactured by MORESCO Corporation) and an Al/PET laminated gas barrier member (manufactured by Toyo Aluminium K.K.), was disposed so as to encapsulate the entire device except for the terminal portion; then, these were bonded using a vacuum laminator (manufactured by Joyo Engineering Co., Ltd.) with an applied pressure of 0.2 MPa.

Next, by using a laser marker (manufactured by Seishin Trading Co., Ltd.), the end of the sealing member in the surface direction was processed such that the length of the insulating layer in the surface direction was equal to or longer than the length of the metal layer in the surface direction, and the length of the metal layer in the surface direction was longer than the length of the base in the surface direction to obtain the photoelectric conversion device. Specifically, the end shape of the sealing member was processed so as to give Δ1 of 0 um and Δ2 of 0.1 um

In the same way as Example 1, the calculation of the short circuit occurrence rate after the surface load test and the measurement of the end shape (Δ1 and Δ2) of the sealing member were carried out. The results are listed in Table 1. 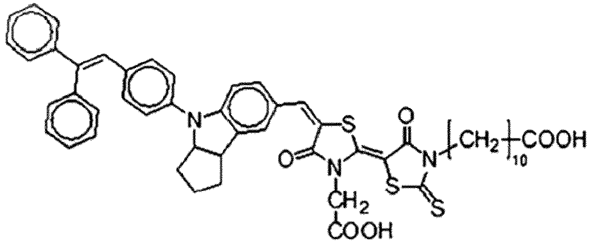 Example Compound 8 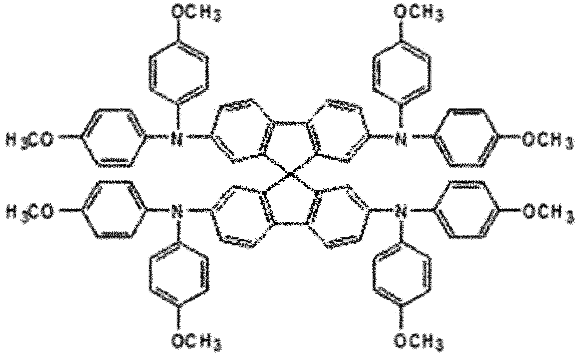 Example Compound 9 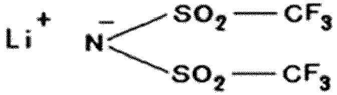 Example Compound 10 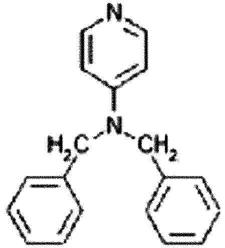 Example Compound 11 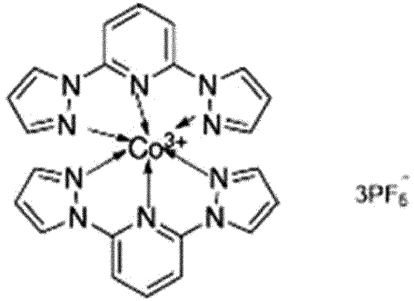 Example Compound 12

### Example 14

### Preparation of Photoelectric Conversion Device

### (Preparation of Dye-sensitized Solar Cell)

In the preparation of the photoelectric conversion device in Example 13, the photoelectric conversion device was prepared in the same way as in Example 13, except that the end shape of the sealing member was processed so as to give Δ1 of 0 um and Δ2 of 1.0 um.

In the same way as Example 1, the calculation of the short circuit occurrence rate after the surface load test and the measurement of the end shape (Δ1 and Δ2) of the sealing member were carried out. The results are listed in Table 1.

### Example 15

### Preparation of Photoelectric Conversion Device

### (Preparation of Perovskite Solar Cell)

First, the solution obtained by dissolving the isopropyl alcohol solution of 0.36 g of titanium diisopropoxide bis(acetylacetone) (75%) in 10 ml of isopropyl alcohol was applied to the FTO glass base by a spin coating method, dried at 120°C for 3 minutes, and then fired at 450°C for 30 minutes to form the first electrode and the dense electron transport layer (dense layer) on the base. The average thickness of the dense layer was made so as to be 10 to 40 um.

Next, a dispersion liquid of titanium oxide paste (trade name: MPT-20, manufactured by Great Cell Solar, Ltd.) diluted with α-terpineol was applied onto the dense layer using a spin-coating method, dried at 120°C for 3 minutes, and then fired at 550°C for 30 minutes.

Next, an acetonitrile solution having 0.1 M (here, M means mol/dm³) lithium bis(trifluoromethanesulfonyl)imide (product number: 38103, manufactured by Kanto Chemical Co., Ltd.) dissolved therein was applied onto the film described above using a spin coating method, and then fired at 450°C for 30 minutes to obtain the porous electron transport layer (porous layer). The average thickness having the porous layer was made so as to be 150 nm.

Next, lead (II) iodide (0.5306 g), lead (II) bromide (0.0736 g), methylamine bromide (0.0224 g), and formamidine iodide (0.1876 g) were added in N,N-dimethylformamide (0.8 ml) and dimethyl sulfoxide (0.2 ml); then, they were heated and stirred at 60°C. The resulting solution was applied onto the porous layer by a spin coating method while adding chloroform (0.3 ml) to form the perovskite film; then, this was dried at 150°C for 30 minutes to obtain the perovskite layer. The average thickness of the perovskite layer was made so as to be 200 to 350 nm. Furthermore, an isopropyl alcohol solution having 1 mM 2-phenylethylammonium bromide dissolved therein was applied onto the formed perovskite layer by a spin coating method.

Next, 73.6 mg of the polymer described in example compound 13 below and 7.4 mg of the additive described in example compound 14 below were weighed and dissolved in 3.0 ml of chlorobenzene. The resulting solution was applied onto the laminate obtained by the above-mentioned process by a spin coating method to obtain the hole transport layer. The average thickness of the hole transport layer (the portion on the perovskite layer) was made so as to be 50 to 120 nm.

Next, the second electrode was formed on the laminate by depositing 100 nm of gold with vacuum vapor deposition.

Next, a material for the surface protection portion composed of a fluorine-based silane compound (DURASURF DS-5935F130; the compound that satisfies the general formula (A), manufactured by Harves Co., Ltd.) was spin-coated onto the second electrode at 1,000 rpm.

Next, in the surface parallel to the light-receiving surface, in the area where no gold is deposited, each layer formed on the outer periphery was removed using a laser processing machine (TOWA Laserfront) to expose the first electrode, thereby forming the sealing zone on the first electrode.

Next, the sealing member, which was formed by sequentially laminating a polyolefin resin adhesive member (pressure-sensitive adhesive resin, manufactured by MORESCO Corporation) and an Al/PET laminated gas barrier member (manufactured by Toyo Aluminium K.K.), was disposed so as to encapsulate the entire device except for the terminal portion; then, these were bonded using a vacuum laminator (manufactured by Joyo Engineering Co., Ltd.) with an applied pressure of 0.2 MPa.

Next, by using a laser marker (manufactured by Seishin Trading Co., Ltd.), the end of the sealing member in the surface direction was processed such that the length of the insulating layer in the surface direction was equal to or longer than the length of the metal layer in the surface direction, and the length of the metal layer in the surface direction was longer than the length of the base in the surface direction to obtain the photoelectric conversion device. Specifically, the end shape of the sealing member was processed so as to give Δ1 of 0 um and Δ2 of 0.1 um

In the same way as Example 1, the calculation of the short circuit occurrence rate after the surface load test and the measurement of the end shape (Δ1 and Δ2) of the sealing member were carried out. The results are listed in Table 1. 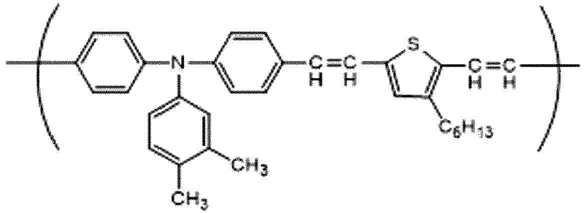 Example Compound 13 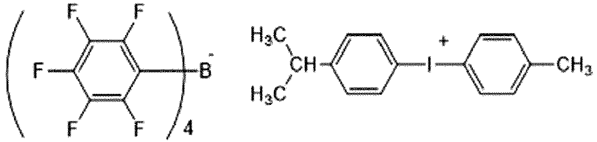 Example Compound 14

### Example 16

### Preparation of Photoelectric Conversion Device

### (Preparation of Perovskite Solar Cell)

In the preparation of the photoelectric conversion device in Example 15, the photoelectric conversion device was prepared in the same way as in Example 15, except that the end shape of the sealing member was processed so as to give Δ1 of 0 um and Δ2 of 1.0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 1

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 2

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of 0 um and Δ2 of -0.5 um.

In the same way as Example 1, the calculation of the short circuit occurrence rate after the surface load test and the measurement of the end shape (Δ1 and Δ2) of the sealing member were carried out. The results are listed in Table 1.

### Comparative Example 3

### Preparation of Photoelectric Conversion Device

### (Preparation of Organic Thin Film Solar Cell)

In the preparation of the photoelectric conversion device in Example 1, the photoelectric conversion device was prepared in the same way as in Example 1 except that the end shape of the sealing member was processed so as to give Δ1 of -0.1 um and Δ2 of 2.0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 4

### Preparation of Photoelectric Conversion Device

### (Preparation of Organic Thin Film Solar Cell)

In the preparation of the photoelectric conversion device in Example 8, the photoelectric conversion device was prepared in the same way as in Example 8 except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 5

### Preparation of Photoelectric Conversion Device

### (Preparation of Organic Thin Film Solar Cell)

In the preparation of the photoelectric conversion device in Example 9, the photoelectric conversion device was prepared in the same way as in Example 9 except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 6

### Preparation of Photoelectric Conversion Device

### (Preparation of Organic Thin Film Solar Cell)

In the preparation of the photoelectric conversion device in Example 10, the photoelectric conversion device was prepared in the same way as in Example 10 except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 7

### Preparation of Photoelectric Conversion Device

### (Preparation of Organic Thin Film Solar Cell)

In the preparation of the photoelectric conversion device in Example 11, the photoelectric conversion device was prepared in the same way as in Example 11 except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 8

### Preparation of Photoelectric Conversion Device

### (Preparation of Organic Thin Film Solar Cell)

In the preparation of the photoelectric conversion device in Example 12, the photoelectric conversion device was prepared in the same way as in Example 12 except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 9

### Preparation of Photoelectric Conversion Device

### (Preparation of Dye-sensitized Solar Cell)

In the preparation of the photoelectric conversion device in Example 13, the photoelectric conversion device was prepared in the same way as in Example 13 except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 10

### Preparation of Photoelectric Conversion Device (Preparation of Dye-sensitized Solar Cell)

In the preparation of the photoelectric conversion device in Example 13, the photoelectric conversion device was prepared in the same way as in Example 13 except that the end shape of the sealing member was processed so as to give Δ1 of -0.1 um and Δ2 of 2.0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 11

### Preparation of Photoelectric Conversion Device (Preparation of Perovskite Solar Cell)

In the preparation of the photoelectric conversion device in Example 15, the photoelectric conversion device was prepared in the same way as in Example 15, except that the end shape of the sealing member was processed so as to give Δ1 of 0 um and Δ2 of 0 um.

In the same way as Example 1, the calculation of the short circuit occurrence rate after the surface load test and the measurement of the end shape (Δ1 and Δ2) of the sealing member were carried out. The results are listed in Table 1.

### Comparative Example 12

### Preparation of Photoelectric Conversion Device

### (Preparation of Perovskite Solar Cell)

In the preparation of the photoelectric conversion device in Example 15, the photoelectric conversion device was prepared in the same way as in Example 15 except that the end shape of the sealing member was processed so as to give Δ1 of -0.1 um and Δ2 of 2.0 um.

In the same way as Example 1, the calculation of the short circuit occurrence rate after the surface load test and the measurement of the end shape (Δ1 and Δ2) of the sealing member were carried out. The results are listed in Table 1.

**Table 1**

| | | Δ1 (µm) | Δ2 (µm) | Short-circuit occurrence rate after surface load test |
|---|---|---|---|---|
| Example | 1 | 5.0 | 10.0 | 0% |
| | 2 | 0 | 10.0 | 0% |
| | 3 | 0 | 2.0 | 0% |
| | 4 | 0 | 1.0 | 0% |
| | 5 | 0 | 0.9 | 2% |
| | 6 | 0 | 0.5 | 4% |
| | 7 | 0 | 0.1 | 6% |
| | 8 | 0 | 0.1 | 6% |
| | 9 | 0 | 0.1 | 6% |
| | 10 | 0 | 0.1 | 6% |
| | 11 | 0 | 0.1 | 6% |
| | 12 | 0 | 0.1 | 8% |
| | 13 | 0 | 0.1 | 6% |
| | 14 | 0 | 1.0 | 0% |
| | 15 | 0 | 0.1 | 6% |
| | 16 | 0 | 1.0 | 0% |
| Comparative Example | 1 | 0 | 0 | 32% |
| | 2 | 0 | -0.5 | 50% |
| | 3 | -0.1 | 2.0 | 54% |
| | 4 | 0 | 0 | 30% |
| | 5 | 0 | 0 | 32% |
| | 6 | 0 | 0 | 34% |
| | 7 | 0 | 0 | 30% |
| | 8 | 0 | 0 | 36% |
| | 9 | 0 | 0 | 30% |
| | 10 | -0.1 | 2.0 | 60% |
| | 11 | 0 | 0 | 34% |
| | 12 | -0.1 | 2.0 | 54% |

The results in Table 1 indicate that the photoelectric conversion devices having Δ1 of 0 um or more and Δ2 of 0.1 um or more can suppress the increase in the short-circuit occurrence rate after the surface load test.

The above-described embodiments are illustrative and do not limit the scope of the appended claims. Thus, numerous additional modifications and variations are possible in light of the above teachings within the scope of the appended claims. For example, at least one element of different illustrative and exemplary embodiments herein may be combined with each other or substituted for each other within the scope of the appended claims. Further, features of components of the embodiments, such as the number, the position, and the shape are not limited the embodiments and thus may be preferably set. It is therefore to be understood that within the scope of the appended claims, the disclosure of the present invention may be practiced otherwise than as specifically described herein.

## Claims

1. A photoelectric conversion device (1) comprising a first electrode (13), a photoelectric conversion layer (16), and a second electrode (18) in sequence, wherein
the photoelectric conversion device (1) comprises a sealing member (20) on a non-facing surface side of one electrode (13, 18) selected from the first electrode (13) and the second electrode (18), the non-facing surface side not facing the photoelectric conversion layer (16),
the sealing member (20) includes an insulating layer (21), a metal layer (23), and a base (24) in sequence from the one electrode, and **characterised in that**
in an end of the sealing member (20) in a surface direction, a length of the insulating layer (21) in the surface direction is equal to or longer than a length of the metal layer (23) in the surface direction, and the length of the metal layer (23) in the surface direction is longer than a length of the base (24) in the surface direction by 0.1 um or more.

2. The photoelectric conversion device (1) according to claim 1, wherein in the end, the length of the metal layer (23) in the surface direction is longer than the length of the base (24) in the surface direction by 1.0 um or more.

3. The photoelectric conversion device (1) according to claim 1 or 2, wherein in the end, a layer thickness of the insulating layer (21) is 50.0 um or less.

4. The photoelectric conversion device (1) according to any one of claims 1 to 3, wherein the insulating layer (21) is a pressure-sensitive adhesive resin.

5. The photoelectric conversion device (1) according to any one of claims 1 to 4, wherein an end of the photoelectric conversion device (1) in the surface direction includes the other electrode (13, 18) selected from the first electrode (13) and the second electrode (18), the insulating layer (21), the metal layer (23), and the base (24) in sequence.

6. The photoelectric conversion device (1) according to any one of claims 1 to 5, comprising the first electrode (13), an electron transport layer, the photoelectric conversion layer (16), a hole transport layer (17), and the second electrode (18) in sequence.

7. The photoelectric conversion device (1) according to any one of claims 1 to 6, wherein the photoelectric conversion layer (16) comprises a compound represented by a following general formula (1): 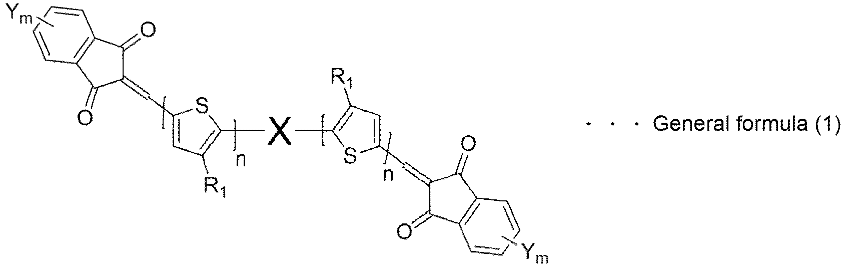
in the general formula (1), R₁ represents an alkyl group having a carbon number of 2 or more and 8 or less, n represents an integer of 1 or more and 3 or less, X is represented by a following general formula (2) or (3), Y represents a halogen atom, and m represents an integer of 0 or more and 4 or less 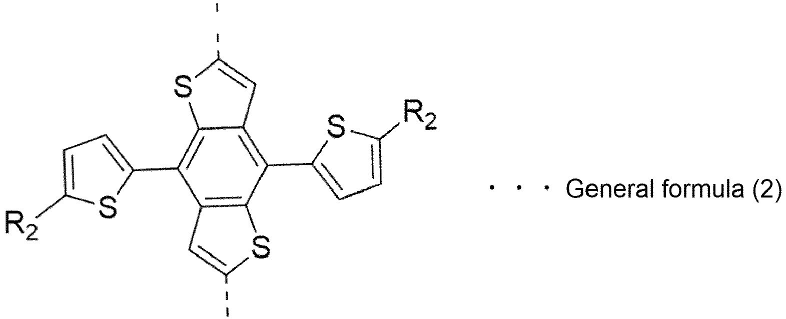
in the general formula (2), R₂ represents a linear or a branched alkyl group 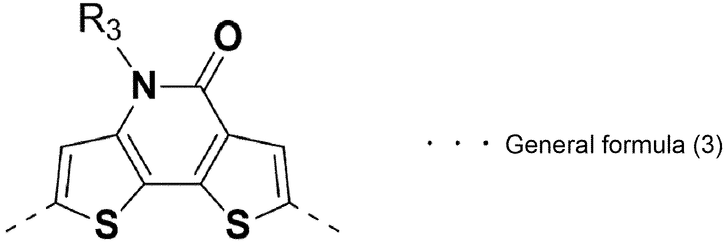
in the general formula (3), R₃ represents a linear or a branched alkyl group.

8. The photoelectric conversion device (1) according to any one of claims 1 to 7, wherein the photoelectric conversion layer (16) comprises an organic material comprising a fullerene derivative.

9. The photoelectric conversion device (1) according to claim 6, wherein the electron transport layer comprises a first electron transport layer (14) and a second electron transport layer (15) arranged between the first electron transport layer (14) and the photoelectric conversion layer (16),
the first electron transport layer (14) contains metal oxide particles, and
the second electron transport layer (15) contains an amine compound represented by a following general formula (4) 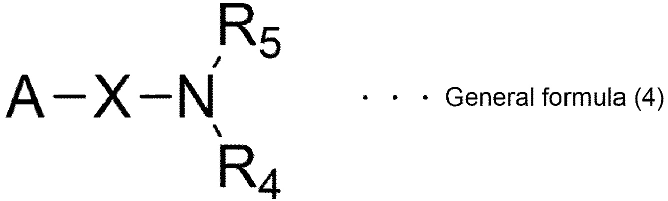
in the general formula (4), R₄ and R₅ each represent an alkyl group which may have a substituent and has a carbon number of 1 or more and 4 or less or a ring structure bonded to R₄ and R₅, X represents a divalent aromatic group having a carbon number of 6 or more and 14 or less or a divalent alkyl group having a carbon number of 1 or more and 4 or less, and A represents one of substituents represented by a following structural formulae (1) to (3)
-COOH · · · Structural formula (1)
-P(=O)(OH)2 · · · Structural formula (2)
-Si(OH)3 · · · Structural formula (3) .

10. An electronic device comprising:
the photoelectric conversion device (1) according to any one of claims 1 to 9; and
a device electrically connected to the photoelectric conversion device (1).

11. An electronic device comprising:
the photoelectric conversion device (1) according to any one of claims 1 to 9;
a storage battery electrically connected to the photoelectric conversion device (1); and
a device electrically connected to the photoelectric conversion device (1) and to the storage battery.

12. A power supply module comprising:
the photoelectric conversion device (1) according to any one of claims 1 to 9; and
a power supply IC electrically connected to the photoelectric conversion device (1).

## Patentansprüche

1. Photoelektrische Umwandlungsvorrichtung (1), die der Reihe nach eine erste Elektrode (13), eine photoelektrische Umwandlungsschicht (16) und eine zweite Elektrode (18) umfasst, wobei
die photoelektrische Umwandlungsvorrichtung (1) ein Abdichtungselement (20) auf einer nicht gegenüberliegenden Oberflächenseite einer Elektrode (13, 18), die aus der ersten Elektrode (13) und der zweiten Elektrode (18) ausgewählt ist, umfasst, wobei die nicht gegenüberliegende Oberflächenseite nicht der photoelektrischen Umwandlungsschicht (16) gegenüberliegt,
das Abdichtungselement (20) von der einen Elektrode aus der Reihe nach eine isolierende Schicht (21), eine Metallschicht (23) und eine Basis (24) umfasst, und
**dadurch gekennzeichnet, dass**
in einem Ende des Abdichtungselements (20) in einer Oberflächenrichtung eine Länge der isolierenden Schicht (21) in der Oberflächenrichtung gleich einer Länge der Metallschicht (23) in der Oberflächenrichtung oder länger als dieselbe ist und die Länge der Metallschicht (23) in der Oberflächenrichtung um 0,1 µm oder mehr länger ist als eine Länge der Basis (24) in der Oberflächenrichtung.

2. Photoelektrische Umwandlungsvorrichtung (1) nach Anspruch 1, wobei in dem Ende die Länge der Metallschicht (23) in der Oberflächenrichtung um 1,0 µm oder mehr länger ist als die Länge der Basis (24) in der Oberflächenrichtung.

3. Photoelektrische Umwandlungsvorrichtung (1) nach Anspruch 1 oder 2, wobei in dem Ende eine Schichtdicke der isolierenden Schicht (21) 50,0 µm oder weniger beträgt.

4. Photoelektrische Umwandlungsvorrichtung (1) nach einem der Ansprüche 1 bis 3, wobei die isolierende Schicht (21) ein Haftklebeharz ist.

5. Photoelektrische Umwandlungsvorrichtung (1) nach einem der Ansprüche 1 bis 4, wobei ein Ende der photoelektrischen Umwandlungsvorrichtung (1) in der Oberflächenrichtung der Reihe nach die andere Elektrode (13, 18), die aus der ersten Elektrode (13) und der zweiten Elektrode (18) ausgewählt ist, die isolierende Schicht (21), die Metallschicht (23) und die Basis (24) einschließt.

6. Photoelektrische Umwandlungsvorrichtung (1) nach einem der Ansprüche 1 bis 5, die der Reihe nach die erste Elektrode (13), eine Elektronentransportschicht, die photoelektrische Umwandlungsschicht (16), eine Lochtransportschicht (17) und die zweite Elektrode (18) umfasst.

7. Photoelektrische Umwandlungsvorrichtung (1) nach einem der Ansprüche 1 bis 6, wobei die photoelektrische Umwandlungsschicht (16) eine Verbindung umfasst, die durch eine folgende allgemeine Formel (1) dargestellt wird: 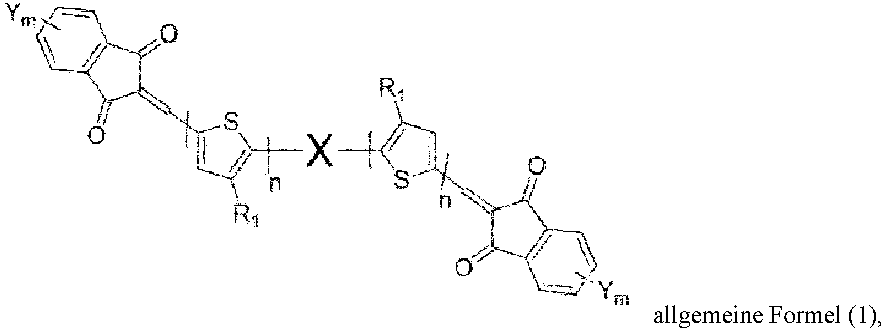
wobei in der allgemeinen Formel (1) Ri eine Alkylgruppe darstellt, die eine Kohlenstoffzahl von 2 oder mehr und 8 oder weniger aufweist, n eine ganze Zahl von 1 oder mehr und 3 oder weniger darstellt, X durch eine folgende allgemeine Formel (2) oder (3) dargestellt wird, Y ein Halogenatom darstellt und m eine ganze Zahl von 0 oder mehr und 4 oder weniger darstellt, 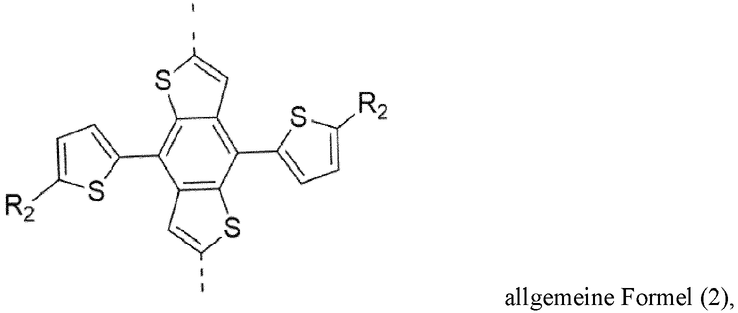
wobei in der allgemeinen Formel (2) R₂ eine lineare oder eine verzweigte Alkylgruppe darstellt, 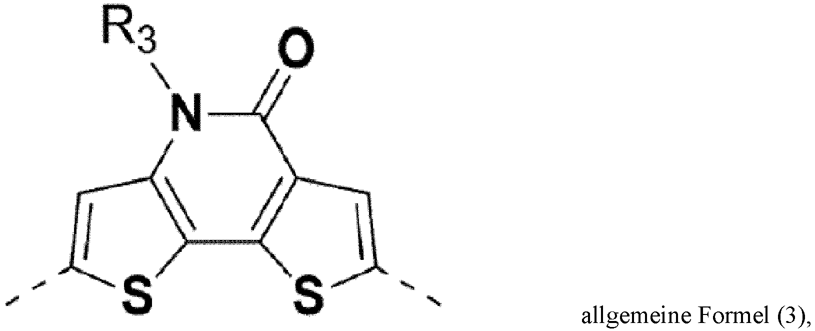
wobei in der allgemeinen Formel (3) R₃ eine lineare oder eine verzweigte Alkylgruppe darstellt.

8. Photoelektrische Umwandlungsvorrichtung (1) nach einem der Ansprüche 1 bis 7, wobei die photoelektrische Umwandlungsschicht (16) ein organisches Material umfasst, das ein Fulleren-Derivat umfasst.

9. Photoelektrische Umwandlungsvorrichtung (1) nach Anspruch 6, wobei die Elektronentransportschicht eine erste Elektronentransportschicht (14) und eine zweite Elektronentransportschicht (15), die zwischen der ersten Elektronentransportschicht (14) und der photoelektrischen Umwandlungsschicht (16) angeordnet ist, umfasst,
die erste Elektronentransportschicht (14) Metalloxidteilchen enthält und
die zweite Elektronentransportschicht (15) eine Amin-Verbindung enthält, die durch eine folgende allgemeine Formel (4) dargestellt wird 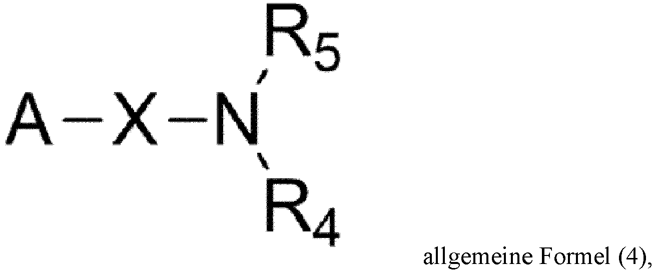
wobei in der allgemeinen Formel (4) R₄ und R₅ jeweils eine Alkylgruppe darstellen, die einen Substituenten aufweisen kann und eine Kohlenstoffzahl von 1 oder mehr und 4 oder weniger oder eine Ringstruktur, die an R₄ und R₅ gebunden ist, aufweist, X eine zweiwertige aromatische Gruppe, die eine Kohlenstoffzahl von 6 oder mehr und 14 oder weniger aufweist oder eine zweiwertige Alkylgruppe, die eine Kohlenstoffzahl von 1 oder mehr und 4 oder weniger aufweist, darstellt und A einen von Substituenten darstellt, die durch eine folgende Strukturformel (1) bis (3) dargestellt werden
-COOH Strukturformel (1),
-P(=O)(OH)₂ Strukturformel (2),
-Si(OH)₃ Strukturformel (3).

10. Elektronische Vorrichtung, die Folgendes umfasst:
die photoelektrische Umwandlungsvorrichtung (1) nach einem der Ansprüche 1 bis 9 und
eine Vorrichtung, die elektrisch mit der photoelektrischen Umwandlungsvorrichtung (1) verbunden ist.

11. Elektronische Vorrichtung, die Folgendes umfasst:
die photoelektrische Umwandlungsvorrichtung (1) nach einem der Ansprüche 1 bis 9,
eine Speicherbatterie, die elektrisch mit der photoelektrischen Umwandlungsvorrichtung (1) verbunden ist, und
eine Vorrichtung, die elektrisch mit der photoelektrischen Umwandlungsvorrichtung (1) und mit der Speicherbatterie verbunden ist.

12. Stromversorgungsmodul, das Folgendes umfasst:
die photoelektrische Umwandlungsvorrichtung (1) nach einem der Ansprüche 1 bis 9 und
einen Stromversorgungs-IC, der elektrisch mit der photoelektrischen Umwandlungsvorrichtung (1) verbunden ist.

## Revendications

1. Dispositif de conversion photoélectrique (1) comprenant une première électrode (13), une couche de conversion photoélectrique (16) et une deuxième électrode (18) dans cet ordre, dans lequel
le dispositif de conversion photoélectrique (1) comprend un élément d'étanchéité (20) sur un côté de surface détourné appartenant d'une électrode (13, 18) sélectionnée parmi les première (13) et deuxième (18) électrodes, le côté de surface détourné étant détourné de la couche de conversion photoélectrique (16),
l'élément d'étanchéité (20) comprenant une couche isolante (21), une couche métallique (23) et une base (24) dans cet ordre à partir de la première électrode, et
**caractérisé en ce que**
dans une extrémité de l'élément d'étanchéité (20) dans une direction de surface, une longueur de la couche isolante (21) dans la direction de surface est égale ou supérieure à une longueur de la couche métallique (23) dans la direction de surface, et la longueur de la couche métallique (23) dans la direction de surface est supérieure de 0,1 µm ou plus à une longueur de la base (24) vue dans la direction de surface.

2. Dispositif de conversion photoélectrique (1) selon la revendication 1, dans lequel, dans l'extrémité, la longueur de la couche métallique (23) dans la direction de surface est supérieure de 1,0 µm ou plus à la longueur de la base (24) dans la direction de surface.

3. Dispositif de conversion photoélectrique (1) selon les revendications 1 ou 2, dans lequel, dans l'extrémité, une épaisseur de couche de la couche isolante (21) est de 50,0 µm ou moins.

4. Dispositif de conversion photoélectrique (1) selon l'une quelconque des revendications 1 à 3, dans lequel la couche isolante (21) est une résine adhésive de contact.

5. Dispositif de conversion photoélectrique (1) selon l'une quelconque des revendications 1 à 4, dans lequel une extrémité du dispositif de conversion photoélectrique (1) dans la direction de surface inclut l'autre électrode (13, 18) sélectionnée parmi les première (13) et deuxième (18) électrodes, la couche isolante (21), la couche métallique (23) et la base (24) dans cet ordre.

6. Dispositif de conversion photoélectrique (1) selon l'une quelconque des revendications 1 à 5, comprenant la première électrode (13), une couche de transport d'électrons, la couche de conversion photoélectrique (16), une couche de transport de trous (17) et la deuxième électrode (18) dans cet ordre.

7. Dispositif de conversion photoélectrique (1) selon l'une quelconque des revendications 1 à 6, dans lequel la couche de conversion photoélectrique (16) comprend un composé représenté par une formule générale (1) suivante : 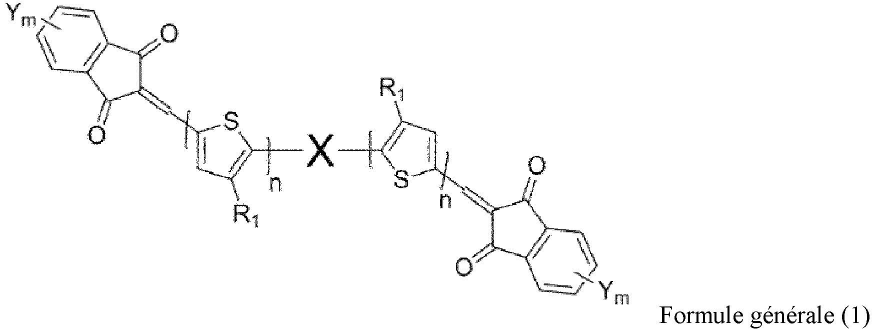
dans la formule générale (1), R₁ représente un groupe alkyle ayant un nombre de carbones de 2 ou plus et de 8 ou moins, n représente un nombre entier de 1 ou plus et de 3 ou moins, X est représenté par une formule générale (2) ou (3) suivante, Y représente un atome d'halogène et m représente un nombre entier de 0 ou plus et de 4 ou moins 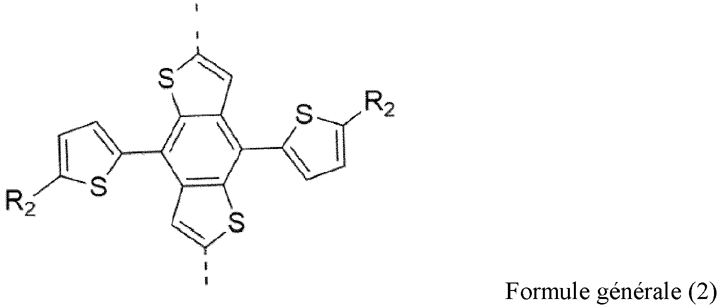
dans la formule générale (2), R₂ représente un groupe alkyle linéaire ou ramifié 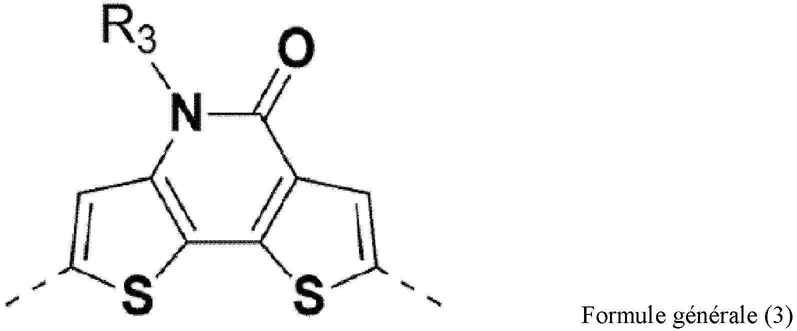
dans la formule générale (3), R₃ représente un groupe alkyle linéaire ou ramifié.

8. Dispositif de conversion photoélectrique (1) selon l'une quelconque des revendications 1 à 7, dans lequel la couche de conversion photoélectrique (16) comprend un matériau organique comprenant un dérivé de fullerène.

9. Dispositif de conversion photoélectrique (1) selon la revendication 6, dans lequel la couche de transport d'électrons comprend une première couche de transport d'électrons (14) et une deuxième couche de transport d'électrons (15) agencée entre la première couche de transport d'électrons (14) et la couche de conversion photoélectrique (16),
la première couche de transport d'électrons (14) contient des particules d'oxyde métallique, et
la deuxième couche de transport d'électrons (15) contient un composé amine représenté par une formule générale (4) suivante : 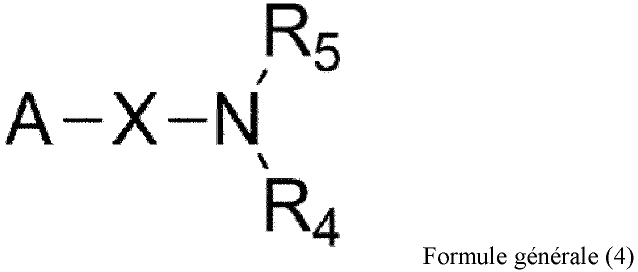
dans la formule générale (4), R₄ et R₅ représentent chacun un groupe alkyle susceptible d'avoir un substituant et ayant un nombre de carbones de 1 ou plus et de 4 ou moins, ou une structure cyclique liée à R₄ et R₅, X représente un groupe aromatique divalent ayant un nombre de carbones de 6 ou plus et de 14 ou moins ou un groupe alkyle divalent ayant un nombre de carbones de 1 ou plus et 4 ou moins, et A représente l'un des substituants représentés par les formules développées (1) à (3) suivantes :
-COOH Formule développée (1)
-P(=O)(OH)₂ Formule développée (2)
-Si(OH)₃ Formule développée (3).

10. Dispositif électronique comprenant :
le dispositif de conversion photoélectrique (1) selon l'une quelconque des revendications 1 à 9, et
un dispositif relié électriquement au dispositif de conversion photoélectrique (1).

11. Dispositif électronique comprenant :
le dispositif de conversion photoélectrique (1) selon l'une quelconque des revendications 1 à 9,
un accumulateur relié électriquement au dispositif de conversion photoélectrique (1), et
un dispositif relié électriquement au dispositif de conversion photoélectrique (1) et à l'accumulateur.

12. Module d'alimentation comprenant :
le dispositif de conversion photoélectrique (1) selon l'une quelconque des revendications 1 à 9, et
un circuit intégré d'alimentation électrique relié électriquement au dispositif de conversion photoélectrique (1).
